(19) Europäisches Patentamt
European Patent Office
Office européen des brevets

(11) **EP 1 704 058 B1**

(12) **EUROPEAN PATENT SPECIFICATION**

(45) Date of publication and mention of the grant of the patent:
**30.06.2010 Bulletin 2010/26**

(21) Application number: **05776963.0**

(22) Date of filing: **30.08.2005**

(51) Int Cl.:
***G11B 7/243*** *(2006.01)* ***G11B 7/26*** *(2006.01)*
***C23C 14/34*** *(2006.01)*

(86) International application number:
**PCT/JP2005/016176**

(87) International publication number:
**WO 2006/025558 (09.03.2006 Gazette 2006/10)**

# (54) WRITE-ONCE-READ-MANY OPTICAL RECORDING MEDIUM AND SPUTTERING TARGET THEREOF

OPTISCHES WORM-AUFZEICHNUNGSMEDIUM (WORM - WRITE-ONCE-READ-MANY) UND SPUTTER-TARGET DAVON

MÉDIA-WORM-D'ENREGISTREMENT OPTIQUE ET CIBLE DE PULVÉRISATION DE CE DERNIER

(84) Designated Contracting States:
**DE ES FR GB IT NL**

(30) Priority:
**31.08.2004 JP 2004252389**
**21.09.2004 JP 2004273774**
**08.03.2005 JP 2005064328**
**11.04.2005 JP 2005113466**

(43) Date of publication of application:
**27.09.2006 Bulletin 2006/39**

(73) Proprietor: **Ricoh Company, Ltd.**
**Tokyo 143-8555 (JP)**

(72) Inventors:
- **HAYASHI, Yoshitaka**
  **Yokohama-shi,**
  **Kanagawa 224-0028 (JP)**
- **FUJII, Toshishige**
  **Yokohama-shi,**
  **Kanagawa 235-0021 (JP)**
- **SASA, Noboru**
  **Yokohama-shi,**
  **Kanagawa 222-0036 (JP)**
- **FUJIWARA, Masayuki**
  **Kawasaki-shi, Kanagawa (JP)**

(74) Representative: **Barz, Peter**
**Patentanwalt**
**Kaiserplatz 2**
**80803 München (DE)**

(56) References cited:

| | |
|---|---|
| EP-A- 1 475 793 | EP-A1- 0 163 378 |
| EP-A2- 0 121 426 | DE-A1- 3 605 793 |
| JP-A- 10 092 027 | JP-A- 10 092 027 |
| JP-A- 59 185 048 | JP-A- 63 094 444 |
| JP-A- 2000 163 804 | JP-A- 2003 048 375 |
| JP-A- 2003 048 375 | JP-A- 2003 203 383 |
| JP-A- 2004 284 018 | US-A- 4 278 734 |
| US-A- 5 491 003 | US-A1- 2004 047 264 |

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 1 704 058 B1

## Description

### Technical Field

The present invention relates to a write-once-read-many (WORM) optical recording medium. More specifically, the present invention relates to a write-once-read-many optical recording medium enabling high density recording particularly at blue-laser wavelengths. The present invention further relates to a sputtering target which can be used for forming an oxide-layer which is a layer constituting the write-once-read-many optical recording medium.

### Background Art

Relating to a write-once-read-many optical recording medium enabling recording and reproducing at laser wavelengths of blue or shorter, a blue laser allowing super high density recording is rapidly developed, and the development of write-once-read-many optical recoding media sensitive to blue-laser wavelengths is promoted.
In conventional write-once-read-many optical recording media, a laser beam is irradiated to a recording layer which comprises an organic material to change the refractive index typically due to the decomposition and degeneration of the organic material, and thus recording pits are formed. The optical constant and decomposition behavior of the organic material used in the recording layer play an important role to form satisfactory recording pits.
For use in a recording layer of write-once-read-many optical recording media sensitive to blue-laser wavelengths, an organic material must have suitable optical properties and decomposition behavior with respect to light at blue-laser wavelengths. More specifically, the wavelengths at which recording is performed are set at a tail on the longer-wavelength side of a major absorption band to increase the reflectance in unrecorded portions and to substantially increase difference in refractive index invited by the decomposition of the organic material upon irradiation of laser to thereby yield a higher modulated amplitude. This is because wavelengths at the tail on the longer-wavelength side of a major absorption band of such an organic material yield an appropriate absorption coefficient and a high refractive index.
However, an organic material having optical properties with respect to light at blue-laser wavelengths equivalent to those of conventional materials has not yet been found. To produce such an organic material having an absorption band in the vicinity of blue-laser wavelengths, the molecular skeleton must be downsized or the conjugate system must be shortened. However, this invites a lowered absorption coefficient and a lowered refractive index. More specifically, there are many organic material having an absorption band in the vicinity of blue-laser wavelengths and it is possible to control their absorption coefficients, however they do not have a sufficiently high refractive index and fail to yield a higher degree of modulated amplitude.
Then the one using inorganic materials and organic materials, and the one using only inorganic materials are presently being studied for a material having optical properties sensitive to light at blue-laser wavelengths. As the one using oxides, Patent Literature 1 discloses a recording layer which comprises Bi, rare-earth, Ga, Fe, and O, and the invention describes a composition capable of forming garnet. Patent Literature 2 discloses an optical recording medium using organic oxides.
However, these conventional techniques do not study in what shape recording marks should be formed to effectively form excellent recording marks and yield excellent properties. As a matter of course, these techniques do not allow for the shape of recording marks to yield higher modulated amplitudes when used with light at blue-wavelengths, which are brought up herein as an issue.
Besides, for write-once-read-many optical recording media using oxides of metals or semimetals as a recording layer, TeOx-Pd recording layers having high-reliabilities have been proposed in Patent Literatures 3 and 4. In Patent Literatures 3 and 4, the composition ratio of the TeOx-Pd recording layer is varied in a direction of the thickness of the layer to enhance reliabilities such as storage stability. Besides, recording layers which comprise TeOx-Pd are also disclosed in Non-Patent Literatures 1 and 2, however, they have only descriptions on controlling of degrees of oxidation therein as a method for improving reliabilities.
As to materials containing a bismuth oxide, which are similar to the present invention though, they are disclosed respectively in the following Patent Literatures: Patent Literature 5 discloses an amorphous and ferromagnetic oxide expressed by the formula $A_x(M_mO_n)_y(Fe_2O_3)_z$, in which individual ratios of various oxides of A, various elements of M, and x, y, and z are defined; Patent Literature 6 discloses a metallic oxide which comprises a 50% or more amorphous phase expressed by the formula $(Bi_2O_3)_x(M_mO_n)_y(Fe_2O_3)_z$, in which individual ratios of m and n of MmOn, individual ratios of x, y, and z are defined, and the production method thereof; Patent Literature 7 discloses an amorphous compound having a composition expressed by the formula $(B_2O_3)_x(Bi_2O_3)_{1-x}$, the range of the composition x, and the quenching method; and Patent Literature 8 discloses bismuth-iron amorphous compound material having a composition of $(Bi_2O_3)_{1-x}(Fe_2O_3)_x$, however, x is represented by $0.90 \geq x > 0$.
However, these techniques respectively relate to amorphous oxide materials which are optically transmissive and ferromagnetic, and they are typically used for photoelectromagnetic optical recording media, functional devices for

controlling light by means of actions of magnetism, photoelectromagnetic sensors, transparent and electrically conductive films, piezo-electric films, and the like. In addition, these techniques provided by other companies basically aim for patents relating to materials and/or production methods of the materials and have no descriptions on applications to write-once-read-many optical recording media.

On the other hand, as one of the methods for producing a recording layer for an optical recording medium, there has been a sputtering method. The sputtering has been widely known in the art as one of the methods for forming thin-layers under vapor-phase and utilized in producing thin-layers for industrial purposes. In the sputtering method, a target material having the same component as that of a layer to be formed is prepared, typically, argon gas ions generated by glow-discharge is crashed with the target material to beat the constituent atoms of the target material, and the atoms are deposited on a substrate to thereby form a layer. An oxide typically has high-melting point, and thus it is not suitably formed by an evaporation method or the like, and the high-frequency-wave sputtering method, in which high-frequency waves are applied, is usually used.

There are many achievements of the sputtering method in its production process, and sputtering is also advantageous in terms of throughput. However, when a layer containing mixed materials from two or more elements is formed, there may be cases where the composition of a target is not same as that of the layer, and therefore, the composition of the target must be considered. Further, there are many cases where the structure and characteristics of a layer vary depending on the configuration of a compound constituting the target, and thus this point must be considered.

As a technique known in the art, for example, Patent Literature 9 discloses a target which comprises a Bi oxide as a sputtering target for forming a dielectric film. However, Patent Literature 9 does not mention a target which comprises Fe. Since when the type of constituent elements varies, the relation between the composition and constituting compound of the target as well as the relation between the structure and composition of a layer vary. Thus, the structure of target must be changed, and the findings disclosed in Patent Literature 9 do not serve as a reference to the sputtering target proposed in the present invention.

In addition, Patent Literature 10 discloses a target for producing a thin layer made from $Bi_3Fe_5O_{12}$, however, the invention is for producing a thin layer having so-called a garnet structure, in which high-degree of magneto-optical effect is obtained, and the invention employs the ratio of Bi to Fe being 3:5 to 3.5:4.5. Accordingly it differs from the sputtering target proposed in the present invention.

Patent Literature 1 Japanese Patent Application Laid-Open (JP-A) No. 10-92027
Patent Literature 2 Japanese Patent Application Laid-Open (JP-A) No. 2003-48375
Patent Literature 3 Japanese Patent Application Laid-Open (JP-A) No. 06-150366
Patent Literature 4 Japanese Patent Application Laid-Open (JP-A) No. 06-93300
Patent Literature 5 Japanese Patent Application Laid-Open (JP-A) No. 61-101450
Patent Literature 6 Japanese Patent Application Laid-Open (JP-A) No. 61-101448
Patent Literature 7 Japanese Patent Application Laid-Open (JP-A) No. 59-8618
Patent Literature 8 Japanese Patent Application Laid-Open (JP-A) No. 59-73438
Patent Literature 9 Japanese Patent Application Laid-Open (JP-A) No. 11-92922
Patent Literature 10 Japanese Patent Application Laid-Open (JP-A) No. 02-42899
Non-Patent Literature 1 pp. 23-28, Proceedings of The 14th Symposium on PCOS2002
Non-Patent Literature 2 pp. 5-8, Vol. 28, Eijogaku Giho

A further prior art used for the two part delimitation of the claims is US-A-4 278 734 describing a rewritable recording medium comprising B: in the recording layer.

Disclosure of Invention

It is therefore an object of the present invention to provide a write-once-read-many optical recording medium capable of presenting excellent recording-reproducing properties at wavelengths of 500nm or less and enabling recording and reproducing particularly at wavelengths of near 405nm and high density recording.

Further, another object of the present invention is to provide a sputtering target which can be used for producing an oxide-layer which is a layer constituting the optical recording medium and is suitably used for arbitrarily forming a layer having a stable composition and a stable structure, and the production method thereof. The invention is defined by the appended claims.

A first aspect of the present invention is a write-once-read-many optical recording medium which comprises a substrate, a recording layer, and a reflective layer, wherein the recording layer comprises a material represented by BiOx ($0 < x < 1.5$), and a recording mark with information recorded therein comprises crystal of Bi and/or crystal of a Bi oxide.

A second aspect of the present invention is a write-once-read-many optical recording medium according to the

first aspect, wherein the recording mark comprises tetravalent Bi.

A third aspect of the present invention is a write-once-read-many optical recording medium which comprises a substrate, a recording layer, and a reflective layer, wherein the recording layer comprises Bi, O, and M as constituent elements, M represents at least one element selected from the group consisting of Mg, Al, Cr, Mn, Co, Fe, Cu, Zn, Li, Si, Ge, Zr, Ti, Hf, Sn, Mo, V, Nb, Y, and Ta, and a recording mark with information recorded therein comprises one or more crystals from crystal of the one or more elements contained in the recording layer and crystal of an oxide of the one or more elements.

A fourth aspect of the present invention is a write-once-read-many optical recording medium according to the third aspect, wherein the recording mark comprises tetravalent Bi.

A fifth aspect of the present invention is a write-once-read-many optical recording medium according to the third aspect, wherein the atomic number ratio of the total amount of the element M to bismuth is 1.25 or less.

A sixth aspect of the present invention is a write-once-read-many optical recording medium according to the third aspect, wherein the write-once-read-many optical recording medium has any one of laminar structures of a laminar structure in which at least the recording layer an upper coating layer, and the reflective layer are disposed on the substrate in this order, and a laminar structure in which at least the reflective layer, an upper coating layer, the recording layer, and a cover layer are disposed on the substrate in this order.

A seventh aspect of the present invention is a write-once-read-many optical recording medium according to the third aspect, wherein the write-once-read-many optical recording medium is produced using a sputtering target which comprises one or more selected from $BiFeO_3$, $Bi_{25}FeO_{40}$, and $Bi_{36}Fe_2O_{57}$.

An eighth aspect of the present invention is a write -once -read-many optical recording medium which comprises a substrate, a recording layer, and a reflective layer, wherein the recording layer comprises Bi, O, and L as constituent elements, and the recording layer comprises a Bi oxide, and L represents at least one element selected from the group consisting of B, P, Ga, As, Se, Tc, Pd, Ag, Sb, Te, W, Re, Os, Ir, Pt, Au, Hg, Tl, Po, At, and Cd.

A ninth aspect of the present invention is a write-once-read-many optical recording medium according to the eighth aspect, wherein the element L represents at least one element selected from the group consisting of B, P, Ga, Se, Pd, Ag, Sb, Te, W, Pt, and Au.

A tenth aspect of the present invention is a write-once-read-many optical recording medium according to the eighth aspect, wherein the atomic number ratio of the total amount of the element L to bismuth is 1.25 or less.

An eleventh aspect of the present invention is a write-once-read-many optical recording medium according to the eighth aspect, wherein the write-once-read-many optical recording medium further comprises an upper coating layer and has a laminar structure in which the recording layer, the upper coating layer, and the reflective layer are disposed on the substrate in this order.

A twelfth aspect of the present invention is a write-once-read-many optical recording medium according to the eleventh aspect, wherein the write-once-read-many optical recording medium further comprises an under coating layer and has a laminar structure in which the under coating layer, the recording layer, the upper coating layer, and the reflective layer are disposed on the substrate in this order.

A thirteenth aspect of the present invention is a write-once-read-many optical recording medium according to the eighth aspect, wherein the write-once-read-many optical recording medium further comprises an upper coating layer and a cover layer and has a laminar structure in which the reflective layer, the upper coating layer, the recording layer, and the cover layer are disposed on the substrate in this order.

A fourteenth aspect of the present invention is a write-once-read-many optical recording medium according to the thirteenth aspect, wherein the write-once-read-many optical recording medium further comprises an under coating layer and has a laminar structure in which the reflective layer, the upper coating layer, the recording layer, the under coating layer, and the cover layer are disposed on the substrate in this order.

A fifteenth aspect of the present invention is a write-once-read-many optical recording medium according to the eighth aspect, wherein the write-once-read-many optical recording medium further comprises at least any one of an under coating layer and an upper coating layer, and at least any one of the under coating layer and the upper coating layer comprises ZnS and/or $SiO_2$.

A sixteenth aspect of the present invention is a write-once-read-many optical recording medium according to the eighth aspect, wherein the write-once-read-many optical recording medium further comprises an under coating layer and an upper coating layer, and at least any one of the under coating layer and the upper coating layer comprises an organic material.

A seventeenth aspect of the present invention is a write-once-read-many optical recording medium according to the eighth aspect, wherein recording and reproducing are enabled with a laser beam having a wavelength of 680nm or less.

An eighteenth aspect of the present invention is a sputtering target which comprises Bi, Fe, and O.

A nineteenth aspect of the present invention is a sputtering target according to the eighteenth aspect, wherein the sputtering target consists of Bi, Fe, and oxygen.

A twentieth aspect of the present invention is a sputtering target according to any one of aspects of the eighteenth aspect to the nineteenth aspect, wherein the sputtering target is used for forming a recording layer for an optical recording medium in which recording and reproducing are performed with a laser beam at a wavelength of 550nm or less.

A twenty-first aspect of the present invention is a sputtering target according to any one of aspects of the eighteenth aspect to the twentieth aspect, wherein the sputtering target comprises a Bi oxide and a Fe oxide, or comprises a complex oxide of Bi and Fe.

A twenty-second aspect of the present invention is a sputtering target according to the twenty-first aspect, wherein the sputtering target comprises the complex oxide of Bi and Fe and further comprises one or more selected from the Bi oxide and the Fe oxide.

A twenty-third aspect of the present invention is a sputtering target according to the eighteenth aspect, wherein the sputtering target comprises one or more selected from a Bi oxide, a Fe oxide, and a complex oxide of Bi and Fe, and the oxide is an oxide having a smaller amount of oxygen compared to the stoichiometric composition.

A twenty-fourth aspect of the present invention is a sputtering target according to any one of aspects of the eighteenth aspect to the twenty-third aspect, wherein the sputtering target comprises one or more selected from $BiFeO_3$, $Bi_{25}FeO_{40}$, and $Bi_{36}Fe_2O_{57}$.

A twenty-fifth aspect of the present invention is a sputtering target according to any one of aspects of the eighteenth aspect to the twenty-fourth aspect, wherein the sputtering target comprises $Bi_2O_3$ and/or $Fe_2O_3$.

A twenty-sixth aspect of the present invention is a sputtering target according to any one of aspects of the eighteenth aspect to the twenty-fifth aspect, wherein the sputtering target does not comprise $Bi_2Fe_4O_9$.

A twenty-seventh aspect of the present invention is a sputtering target according to any one of aspects of the eighteenth aspect to the twenty-sixth aspect, wherein the content of Co, Ca, and Cr is less than the detection limit of the inductively coupled plasma emission spectrometry.

A twenty-eighth aspect of the present invention is a sputtering target according to any one of aspects of the eighteenth aspect to the twenty-seventh aspect, wherein the sputtering target has a packing density of 65% to 96%.

A twenty-ninth aspect of the present invention is a sputtering target according to any one of aspects of the eighteenth aspect to the twenty-eighth aspect, wherein the atomic ratio of Bi and Fe satisfies the requirement of $Bi/Fe \geq 0.8$.

A thirtieth aspect of the present invention is a sputtering target production method in which powders of $Bi_2O_3$ and $Fe_2O_3$ are calcined to produce a sputtering target according to any one of aspects of the eighteenth aspect to the twenty-ninth aspect.

A thirty-first aspect of the present invention is an optical recording medium which comprises a substrate, a recording layer, and a reflective layer, wherein the recording layer is formed using a sputtering target which comprises one or more selected from $BiFeO_3$, $Bi_{25}FeO_{40}$, and $Bi_{36}Fe_2O_{57}$.

## Brief Description of Drawings

FIG. 1 is a diagram showing radial distribution functions in the vicinity of O (oxygen) atoms in an unrecorded portion and a recorded portion.

FIG. 2 is a diagram showing radial distribution functions in the vicinity of O (oxygen) atoms of a Bi oxide measured according to the FEFF calculation.

FIG. 3 is a diagram showing the measurement results of Example B-26.

FIG. 4 is a diagram showing an X-ray diffraction pattern of a sputtering target 1.

FIG. 5 is a diagram showing recording properties of an optical recording medium produced by using the sputtering target 1.

FIG. 6 is a diagram showing an X-ray diffraction pattern of a sputtering target 2.

FIG. 7 is a diagram showing recording properties of an optical recording medium produced by using the sputtering target 2.

FIG. 8 is a diagram showing an X-ray diffraction pattern of a sputtering target 3.

FIG. 9 is a diagram showing an X-ray diffraction pattern of a sputtering target 4.

FIG. 10 is a diagram showing recording properties of an optical recording medium produced by using a sputtering target which has a different ratio of Bi/Fe.

FIG. 11 is a diagram showing an X-ray diffraction pattern of a sputtering target 5.

FIG. 12 is a diagram showing an X-ray diffraction pattern of a sputtering target 7.

## Best Mode for Carrying Out the Invention

Hereinafter, the present invention will be described in detail.

To achieve a write-once-read-many optical recording medium capable of performing excellent recording at a wavelength of blue-laser wavelengths or shorter, the following items (1) to (3) are taken up as important issues:

(1) Small recording marks can be formed.
(2) Less interference between recording marks
(3) High-stability in recoding marks

When a blue-laser is used, a material by which recording can be excellently performed at blue-wavelengths must be selected, unlike in the case where a laser is used at near-infrared wavelengths and red-wavelengths used for CD and DVD.

Since a Bi oxide easily absorbs light at blue-wavelengths, excellent recording can be expected.

The first aspect of a write-once-read-many optical recording medium according to the present invention comprises a substrate, a recording layer, and a reflective layer, in which a material represented by BiOx ($0 < x < 1.5$) is used for the recording layer, and recording marks with information recorded therein comprise crystal of Bi and/or crystal of a Bi oxide. To yield a higher modulated amplitude, it is required that the difference in refractive index between a recorded mark and an unrecorded portion be large. When a material represented by BiOx ($0 < x < 1.5$) is used for a recording layer so as to form crystal of Bi and/or crystal of a Bi oxide in a recording mark, the variance in refractive index is larger, and higher modulated amplitude can be realized. For example, when an unrecorded portion is amorphous and a recoding mark comprises a crystallized portion, higher modulated amplitude can be yielded. When an unrecorded portion comprises a Bi oxide, by forming precipitation of a simple substance of Bi-metal, not oxide, in a recording mark, the difference in refractive index is much larger, and much higher modulated amplitude can be yielded. The method for forming a recording mark by crystallizing amorphous portions has been used so far, however, in the present invention, when recording is performed in an oxide, much greater effect can be expected by utilizing the phenomenon that the recorded portion is changed to a substance other than oxides and the recorded portion is crystallized. A recording mark which comprises crystals having two or more different crystal-structures can restrain the crystals from growing and spreading and enables forming a small recording mark, because mixed crystals each having a different crystal structure can restrain the growth of crystals.

The changes in a recording layer induced by recording will be described more.

The material represented by BiOx ($0 < x < 1.5$) is in a metastable state which is hard to exist with normal conditions, however; such a state can be realized in an optical recording medium by forming a recording layer by sputtering. When a laser beam is irradiated to a recording layer in a metastable state of BiOx ($0 < x < 1.5$) to increase the temperature, it is easily to separate into Bi and a Bi oxide, because BiOx attempts to go back to a more stable state. At this point in time, it is believed that some Bi oxides isolate from oxygen to become no longer an oxide to be in a state of Bi. Since a more stable state is a crystalline state, crystal of Bi and crystal of a Bi oxide are formed, and thus a recording mark becomes in a state where crystal of Bi and/or crystal of a Bi oxide are included.

An aspect of the write-once-read-any optical recording medium of the present invention comprises a substrate, a recording layer, and a reflective layer, wherein the recording layer comprises Bi, O, and M as constituent elements, wherein M represents at least one element selected from the group consisting of Mg, Al, Cr, Mn, Co, Fe, Cu, Zn, Li, Si, Ge, Zr, Ti, Hf, Sn, Mo, V, Nb, Y, and Ta, and a recording mark with information recorded therein comprises one or more crystals from crystal of the one or more elements contained in the recording layer and crystal of an oxide of the one or more elements. An another aspect of the write-once-read-many optical recording medium comprises a substrate, a recording layer, and a reflective layer, wherein the recording layer comprises Bi, O, and L as constituent elements, and the recording layer comprises a Bi oxide, and L represents at least one element selected from the group consisting of B, P, Ga, As, Se, Tc, Pd, Ag, Sb, Te, W, Re, Os, Ir, Pt, Au, Hg, Tl, Po, At, and Cd.

Bismuth may be contained in any of the states such as metallic bismuths, bismuth alloys, bismuth oxides, bismuth sulfides, bismuth nitrides, bismuth fluorides, however, the recording layer preferably comprises one bismuth oxide. Since a recording layer containing a bismuth oxide enables lowering thermal conductivity of the recording layer, achieving high-sensitivities and lower jitter values, and making an imaginary part of complex index of refraction smaller, the recording layer has an excellent transparency, and a multi-layered recording layer is easily formed.

Preferably, bismuth and one or more elements selected from the group consisting Mg, Al, Cr, Mn, Co, Fe, Cu, Zn, Li, Si, Ge, Zr, Ti, Hf, Sn, Mo, V, Nb, Y, Ta, B, P, Ga, As, Se, Te, Pd, Ag, Sb, Te, W, Re, Os, Ir, Pt, Au, Hg, Tl, Po, At, and Cd reside in the recording layer in an oxidized state from the perspective of improvements in stability and thermal conductivity, however, they are not necessarily oxidized completely. In other words, when the recording layer of the present invention comprises three elements of bismuth, oxygen, and one element such as Mg, it may comprise bismuth, a bismuth oxide, an element such as Mg, and an oxide of the element such as Mg.

Examples of the method for making bismuth or metallic bismuth and a Bi oxide mixed in the recording layer, i.e. the method for forming a recording layer in which bismuth elements reside in different states include the following methods (A) to (C).

(A) Sputtering the recording layer using a bismuth-oxide target

(B) Sputtering the recording layer using a bismuth target and a bismuth-oxide target

(C) Sputtering the recording layer using a bismuth target while introducing oxygen into the recording layer or co-sputtering method

When the method (A) is employed, bismuth in the target is completely oxidized, and this method utilizes the phenomenon that oxygen is likely to be deficient depending on the sputtering conditions such as degree of vacuum and sputtering power.

First, an aspect of the write-once-read-many recording medium in which the recording layer comprises Bi, M and oxygen as constituent elements will be described below. It is noted that the element M represents at least one element selected from the group consisting of Mg, Al, Cr, Mn, Co, Fe, Cu, Zn, Li, Si, Ge, Zr, Ti, Hf, Sn, Mo, V, Nb, Y, and Ta.

Recording can be excellently performed to light at blue-wavelengths by using a material which comprises Bi, M, and oxygen for a recording layer. In an aspect of the write-once-read-many optical recording medium of the present invention, in which a recording layer comprises M, by forming a recording mark in a state where crystals of two or more types of oxides are mixed, the difference in refractive index between a recording mark and an unrecorded portion is larger, and higher modulated amplitudes can be yielded. Further, greater effects can be obtained by making not only crystal of respective oxides but also crystal of a simple substance of element reside in the recording layer. Since growth of crystals can be restrained by making crystals of different elements or crystals each having a different crystal structure mixed, a recording mark which comprises crystals of two or more different elements and/or crystal-structures can restrain the crystals from growing and spreading and makes it possible to form a small recording mark.

A recording mark preferably comprises tetravalent Bi. Typically, as the valence of Bi, trivalent Bi is in the most stable state, however to yield a much higher modulated amplitude, a tetravalent Bi is used. It is possible to make the valence of Bi into tetravalence depending on the conditions of oxygen surrounding a Bi atom. Since physical properties are changed by changing the valence of Bi, higher modulated amplitude can be yielded.

Examples of the tetravalent Bi compound include $BiO_2$. Typically, a Bi-oxide having a structure of $Bi_2O_3$ is in a stable state. However, a Bi-oxide can take a structure like $BiO_2$ depending on the conditions. By making a recording layer have a crystalline structure that is not typically employed, higher modulated amplitudes can be yielded.

A still another aspect of the write-once-read-many optical recording medium of the present invention will be described below. In the write-once-read-many optical recording medium, a recording layer comprises Bi, L, oxygen, and a Bi oxide as constituent elements. It is noted that the element L represents at least one element selected from the group consisting of B, P, Ga, As, Se, Tc, Pd, Ag, Sb, Te, W, Re, Os, Ir, Pt, Au, Hg, Tl, Po, At, and Cd. The recording layer comprises bismuth as the principal constituent. As an element to be added to the recording layer which comprises Bi and O as constituent elements, the element M can be named. However, the study about basic properties of the constituent elements that can be added to the constituent elements shows that the element L can also be named. One of the reasons why the element L can be added as a constituent element to a recording layer which comprises bismuth as the principal constituent and comprises a Bi oxide is to reduce thermal conductivity to facilitate forming a minute recording mark. Since thermal conductivity is a value attributable to the presence of photon scattering, thermal conductivity can be reduced when the particle size and crystal size are downsized, when there are a number of atoms constituting a material, and when the difference in atomic mass of constituent atoms is large, and the like. Thus, by adding the element L as a constituent element to a recording layer which comprises bismuth as the principal constituent and comprises a Bi oxide, it is possible to control thermal conductivity and improve high density recording properties.

Further, in a recording layer which comprises bismuth as the principal constituent and further comprises a bismuth oxide, the bismuth oxide and the bismuth are crystallized by recording of information, however the size of the crystal and crystallized particles can be controlled by the element L. Thus, the element L enables controlling the size of crystal and crystallized particles in recorded portions and greatly improving recording and reproducing properties such as jitter. This is another reason for adding the element L as a constituent element to a recording layer.

From the perspective of thermal conductivity, there are little requirements that are assumed by the element L which can be added as a constituent element to the recording layer except for simple requirements such as the stability of raw materials and the difficulty level of production. However, the inventors of the present invention found that reliabilities of a recording layer, i.e. reproducing stability and storage stability substantially vary depending on the selected element L, and definitely there are requirements assumed by the element L with respect to reliabilities.

Namely, as a result of keen examinations on the requirements of the element L to be added as a constituent element to the recording layer, the inventors of the present invention found that the following requirements (I) or (II) are effective:

(I) An element having a Pauling's electronegativity value of 1,80 or more.

(II) An element having a Pauling's electronegativity value of 1.65 or more and the standard enthalpy of formation $\Delta H_f0$ of oxides of -1,000 (kJ/mol) or more, excluding transition metals.

By using an element L satisfying (I) or (II), it is possible to achieve a write-once-read-many optical recording medium having excellent recording and reproducing properties such as jitter, and high-reliabilities.

Hereinafter, the requirements (I) and (II) will be explained in detail.

Degradation in reliabilities of the recording layer which comprises bismuth as the principal constituent of constituent elements and comprises a bismuth oxide is primarily caused by progression of oxidation, or changes in oxidization state such as changes in the valence, and the like. Pauling's electronegativity values and the standard enthalpy of formation "$\Delta H_f 0$" of oxides are really important as physical property values of the element L, because the progression of oxidation and changes in oxidization state are liable to invite degraded reliabilities. To sufficiently enhance reliabilities of an optical recording medium, first, it is preferred to select an element having a Pauling's electronegativity value of 1.80 or more as an element L. This is because oxidation is unlikely to make progress with an element having a high Pauling's electronegativity value, and to secure satisfactory reliabilities, an element having a Pauling's electronegativity value of 1.80 or more is effective. The standard enthalpy of formation of "$\Delta H_f 0$" of oxides may take any values, provided that the Pauling's electronegativity value is 1.80 or more.

Examples of the element L having an electronegativity of 1.80 or more include B, Si, P, Fe, Co, Ni, Cu, Ga, Ge, As, Se, Mo, Tc, Ru, Rh, Pd, Ag, Sn, Sb, Te, W, Re, Os, Ir, Pt, Au, Hg, Tl, Pb, Po, and At.

Here, the electronegativity will be described briefly.

The electronegativity is a scale representing how strongly the existing atom in a molecule can attract electrons thereto. The ways to determine a value of electronegativity include Pauling's electronegativity, Mulliken's electronegativity, and Allred-Rochow's electronegativity. In the present invention, the adequacy of an element L is determined by using Pauling's electronegativity.

The Pauling's electronegativity defines that the binding energy E (AB) of molecules A and B is greater than the average of binding energy of molecules AA and molecules BB [E (AA) and E (BB), respectively], and the difference therebetween is a square of the difference between the electronegativity of the respective atoms ($X_A$, $X_B$). Namely, it is represented by the following formula:

$$E\,(AB) - [E\,(AA) + E\,(BB)]\,/\,2 = 96.48\,(X_A - X_B)^2 \quad ....(1)$$

In Pauling's electronegativity, the equation includes a conversion coefficient of 96.48 (leV = 96.48kJmol$^{-1}$), because a value of electronegativity is determined by using electron volt.

Since the electronegativity varies depending on with what valence an intended element takes in a molecule, the following definitions are applied when the electronegativity is determined in the present invention.

Namely, as shown below, the value when the following each group element respectively takes the following valence is defined as the Pauling's electronegativity value of the element:

Elements in 1 group take monovalence; elements in 2 group take divalence; elements in 3 group take trivalence; elements in 4 group to 10 group take divalence; elements in 11 group take monovalence; elements in 12 group take divalence; elements in 13 group take trivalence; elements in 14 group take tetravalence; elements in 15 group take trivalence; elements in 16 group take divalence; elements in 17 group take monovalence; and elements in 18 group take zero valence.

For the above-noted elements each having electronegativity of 1.80 or more, the respective Pauling's electronegativity values defined in the present invention are B (2.04), Si (1.90), P (2.19), Fe (1.83), Co (1.88), Ni (1.91), Cu (1.90), Ga (1.81), Ge (2.01), As (2.18), Se (2.55), Mo (2.16), Tc (1.90), Ru (2.20), Rh (2.28), Pd (2.20), Ag (1.93), Sn (1.96), Sb (2.05), Te (2.10), W (2.36), Re (1.90), Os (2.20), Ir (2.20), Pt (2.28), Au (2.54), Hg (2.00), Tl (2.04), Pb (2.33), Po (2.00), and At (2.20).

These elements can be added in combination with two or more as constituent elements to a recording layer.

Further, the inventors of the present invention found that even if the Pauling's electronegativity value is less than 1,80, an element having a Pauling's electronegativity value of 1.65 or more and the standard enthalpy of formation $\Delta H_f^0$ of oxides of the element being -1,000 (kJ/mol) or more enables ensuring satisfactory reliabilities. The reason why the requirement is effective is because when an element having a great value of standard enthalpy of formation $\Delta H_f^0$ of oxides, the element is hard to form oxides thereof even if the value of Pauling's electronegativity value is small in some degree.

In the present invention, when determining a Pauling's electronegativity value, it was determined with each valence fixed to every group of elements, and the same definitions are applied when determining the standard enthalpy of formation $\Delta H_f^0$.

Namely, the value when an oxide is constituted with the following each valence in each group element is defined as the standard enthalpy $\Delta H_f^0$ of formation of the element.

Namely, elements in group 1 take monovalence; elements in 2 group take divalence; elements in 3 group take

trivalence; elements in 4 group to 10 group take divalence; elements in 11 group take monovalence; elements in 12 group take divalence; elements in 13 group take trivalence; elements in 14 group take tetravalence; elements in 15 group take trivalence; elements in 16 group take divalence; and elements in 17 group take monovalence; and elements in 18 group take zero valence. However, in the case of a transition metal, it is impossible to easily determine the standard enthalpy of formation $\Delta H_f^0$ of oxide thereof, because it forms an oxide with various valences. Typically, the higher the valence of the element which forms an oxide thereof is, the lower the standard enthalpy of formation $\Delta H_f^0$ of the oxide is.

In other words, it is considered that in the case of a transition metal, an oxide or oxides thereof are easily formed because there are oxides having various valences to be formed, and thus in the present invention transition metals are not preferably used as an element L.

For example, since V (vanadium) takes divalence, the standard enthalpy of formation $\Delta H_f^0$ of a V (vanadium) oxide takes the value of the standard enthalpy $\Delta H_f^0$ of formation of VO = -431 ($kJmol^{-1}$), and it falls under the requirements for the element L (II) in the present invention. However, V (vanadium) also easily forms oxides such as $V_2O_3$ (trivalence), $V_2O_4$

(tetravalence), $V_2O_5$ (pentavalence). The $\Delta H_f^0$ values of these oxides are respectively $V_2O_3$ (-1,218$kJmol^{-1}$), $V_2O_4$ (-1,424$kJmol^{-1}$), $V_2O_5$ (-1,550$kJmol^{-1}$), and these values do not fall under the requirements for the element L (II) in the present invention. Namely, assuming that V forms oxides with almost only divalence, V (vanadium) falls under the requirements of (I) and (II) of the present invention, however V (vanadium) easily forms oxides other than divalent oxides, and the oxides are easily oxidized, i.e. are in a more stable state. Thus, these oxides are excluded from the preferred element L of the present invention.

The description of the exclusion is clearly described in the requirement (II) for the element L in the present invention as "excluding transition metals."

Here, the standard enthalpy of formation $\Delta H_f^0$ will be described briefly.

Typically, a chemical reaction is represented by the following chemical equation (2):

$$H_2\ (gas) + (1/2)\ O_2\ (gas) = H_2O\ (liquid)\ .....(2)$$

The left side of the chemical equation is referred to as original system, and the right side thereof is referred to as product. The coefficient attached to a molecule is called a stoichiometric coefficient.

Heat moves in and out associated with a chemical reaction of the system at a constant temperature is called heat of reaction, and heat of reaction at a constant pressure is called heat of reaction at constant pressure.

In most cases, under typical laboratory conditions, heat of reaction is measured at a constant pressure, therefore, heat of reaction at constant pressure is typically used. Heat of reaction at constant pressure is equal to the difference in enthalpy "$\Delta H$" between product and original system.

A reaction expressed as $\Delta H > 0$ is referred to as endothermic reaction, and a reaction expressed as $\Delta H < 0$ is referred to as exothermic reaction.

Heat of reaction generated from a reaction forming a compound from a chemical element of the compound is called heat of formation or enthalpy of formation. Heat of reaction generated from a reaction forming one mole compound in standard condition from a chemical element of the compound is called standard enthalpy of formation. In the standard condition, the standard enthalpy of formation is marked with a designated temperature, typically 298K, under a pressure of 0.1MPa or nearly equal to 1 atmospheric pressure, and the standard enthalpy of formation is represented by the symbol of $\Delta H_f^0$. In the standard condition, it is ruled that enthalpies of respective chemical elements are zero.

Thus, it can be said that the smaller the value of standard enthalpy of formation of oxide of an element is or the greater in negative value of the standard enthalpy of formation is, the oxide is more stable and the element is easily oxidized.

The specific values of the standard enthalpy of formation are written, for example, in "Electrochemistry Handbook Vol. 5" (Denki-kagaku Binran) edited by The Electrochemistry Society of Japan, Maruzen).

Since the standard enthalpy of formation $\Delta H_f^0$ varies depending on with what valence an intended element takes in a molecule to form an oxide thereof, the above-noted requirements are applied when the standard enthalpy of formation of oxides of respective elements is determined in the present invention.

Examples of elements having a Pauling's electronegativity value of 1.65 or more and the standard enthalpy of formation of oxides thereof $\Delta H_f^0$ of -1,000 (kJ/mol) or more include Zn, Cd, and In. For the Pauling's electronegativity value according to the definitions of the present invention, these elements respectively are determined as follows: Zn (1.65), Cd (1.69), and In (1.78). For the standard enthalpy of formation $\Delta H_f^0$ according to the definitions of the present invention, they are respectively determined as follows: Zn (-348$kJmol^{-1}$), Cd (-258$kJmol^{-1}$), and In (-925$kJmol^{-1}$).

The atomic number ratio of the total amount of the element L to bismuth is preferably 1.25 or less.

Since a recording layer of the present invention is based on the assumption that it comprises bismuth as the

principal constituent of the recording layer and also comprises a Bi oxide, when the atomic number ratio of the total amount of the element L to bismuth is more than 1.25, intrinsic recording and reproducing properties may not be obtained.

Further, adding B, P, Ga, Se, Pd, Ag, Sb, Te, W, Pt, and Au as an element L to the recording layer is preferable from the perspective of improving storage stability of the recording layer. The improvement of storage stability is very likely to be caused by the fact that it is hard to break a once-formed crystalline structure by strengthening binding force between the atoms or when atoms in different size reside side-by-side, it makes the crystalline structure stable because smaller atoms in size can reside in lattices of greater atoms in size. In particular, elements such as B and Pd are bound to oxygen, and when making Bi and O exist together is effective in stabilizing an amorphous structure. It may consequently stabilize the structure of the crystal, which leads to improvements in storage stability of the write-once-read-many recording medium.

In a write-once-read-many optical recording medium of the present invention, it is preferred that recording and reproducing of information be performed through the use of a laser beam at a wavelength of 680nm or less. Unlike dyes, the recording layer of the present invention has an appropriate absorption coefficient at a wide range of wavelengths and has a high refractive index, and therefore it is possible to perform recording and reproducing with a laser beam at a red-laser wavelength of 680nm or less as well as to achieve excellent recording and reproducing properties and high-reliabilities. Among them, the most preferable advantage is to perform recording and reproducing with a laser beam at a wavelength of 450nm or less. This is because the recording layer having bismuth as the principal constituent and having a Bi oxide has a complex refractive index particularly suitable for a write-once-read-many optical recording medium used with a laser beam at a wavelength of 450nm or less.

A write-once-read-many optical recording medium according to the present invention preferably has the following configurations, however they are not particularly limited to the configurations.

(A) Substrate, recording layer, upper coating layer, and reflective layer
(B) Substrate, under coating layer, recording layer, upper coating layer, and reflective layer
(C) Substrate, reflective layer, upper coating layer, recording layer, and cover layer
(D) Substrate, reflective layer, upper coating layer, recording layer, under coating layer, and cover layer.

Further, on the basis of the above configurations, a structure of layers may be formed in a multi-layered structure. For example, when formed in two-layered based on the configuration of (A), it may has a configuration as follows: Substrate, recording layer, upper coating layer, reflective layer or semi-transparent layer, binder layer, recording layer, upper coating layer, reflective layer, and substrate.

For the under coating layer and the upper coating layer, the following oxides and nonoxides are available: examples of the oxides include simple oxide such as $B_2O_5$, $Sm_2O_3$, $Ce_2O_3$, $Al_2O_3$, MgO, BeO, $ZrO_2$, $UO_2$, and $ThO_2$; silicate such as $SiO_2$, $2MgO{\cdot}SiO_2$, $MgO{\cdot}SiO_2$, $CaO{\cdot}SiO_3$, $ZrO_2{\cdot}SiO_2$, $3Al_2O_3{\cdot}2SiO_2$, $2MgO{\cdot}2Al_2O_3{\cdot}5SiO_2$, $Li_2O{\cdot}Al_2O_3{\cdot}4SiO_2$; double oxide such as $Al_2TiO_5$, $MgAl_2O_4$, $Ca_{10}(PO_4)_6(OH)_2$, $BaTiO_3$, $LiNbO_3$, PZT [Pb (Zr, Ti) $O_3$], PLZT [(Pb, La) (Zr, Ti) $O_3$], and ferrite. Examples of the nonoxides include nitrides such as $Si_3N_4$, AlN, BN, and TiN; carbides such as SiC, $B_4C$, TiC, and WC; borides such as $LaB_6$, $TiB_2$, and $ZrB_2$; sulfides such as ZnS, CdS, and $MoS_2$; silicides such as $MoSi_2$; and carbons such as amorphous carbon, graphite, and diamond.

Organic materials such as dyes and resins can also be used for the under coating layer and the upper coating layer.

Examples of the dyes include polymethine dyes, naphthalocyanine dyes, phthalocyanine dyes, squarylium dyes, chroconium dyes, pyrylium dyes, naphthoquinone dyes, anthraquinone (indanthrene) dyes, xanthene dyes, triphenylmethane dyes, azulene dyes, tetrahydrocholine dyes, phenanthrene dyes, triphenothiazine dyes, azo dyes, formazan dyes, and metal complexes of these compounds.

Examples of the resins include polyvinyl alcohols, polyvinyl pyrrolidones, cellulose nitrates, cellulose acetates, ketone resins, acrylic resins, polystyrene resins, urethane resins, polyvinyl butyrals, polycarbonates, and polyolefins. Each of these resins may be used alone or in combination with two or more.

A layer which comprises organic materials can be formed by means of vapor depositions, sputtering, CVD, i.e. Chemical Vapor Deposition, coating of a solvent or the like, which are typically used. When a coating method is used, the above-noted organic materials and the like are dissolved in an organic solvent and the solvent is coated by a commonly used coating method such as spraying, roller-coating, dipping, and spin-coating.

Examples of typical organic solvents to be used include alcohols such as methanol, ethanol, and isopropanol; ketones such as acetone, methyl ethyl ketone, and cyclohexanone; amides such as N, N-dimethylacetoamide, and N, N-dimethylformamide; sulfoxides such as dimethylsulfoxide; ethers such as tetrahydrofuran, dioxane, diethyl ether, and ethylene glycol monomethyl ether; esters such as methyl acetate, and ethyl acetate; aliphatic halocarbons such as chloroform, methylenechloride, dichloroethane, carbon tetrachloride, and trichloroethane; aromatic series such as benzene, xylene, monochlorobenzene, and dichlorobenzene; cellosolves such as methoxyethanol, and ethoxyethanol; and hydrocarbons such as hexane, pentane, cyclohexane, and methylcyclohexane.

For the reflective layer, light reflection materials having high reflectance against laser beams are used.

Examples of the light reflection materials include metals such as Al, Al-Ti, Al-In, Al-Nb, Au, Ag, and Cu, semimetals, and alloys thereof. Each of these materials may be used alone and in combination with two or more.

When a reflective layer is formed with an alloy, it is possible to prepare it by using an alloy as a target material and by sputtering. Besides, it is also possible to form a reflective layer by tip-on-target method (for example, a Cu tip is placed on an Ag target material to form a reflective layer), and by cosputtering (for example, an Ag target and a Cu target are used).

It is also possible to alternately stack low-refractive index layers and high-refractive index layers and form a multi-layered structure to use it as a reflective layer.

A reflective layer may be formed, for example, by sputtering, ion-plating, chemical vapor deposition, and vacuum deposition. The reflective layer preferably has a thickness of 5nm to 300nm.

Materials for a substrate are not particularly limited, as long as they have excellent thermal and machine properties, and when recording and reproducing is performed from the side of a substrate and through the substrate, they have also excellent light transmission properties.

Specifically, examples thereof include polycarbonates, polymethyl methacrylates, amorphous polyolefins, cellulose acetates, polyethylene terephthalate, of which polycarbonates and amorphous polyolefins are preferable.

The thickness of the substrate varies depending on the application and is not particularly limited.

Materials for a protective layer to be formed on a reflective layer, an optically transparent layer or the like are not particularly limited, provided that the material can protect reflective layers, optically transparent layers or the like from external forces. Examples of organic materials include thermoplastic resins, thermosetting resins, electron beam curable resins, and ultraviolet curable resins. Examples of inorganic materials include $SiO_2$, $Si_3N_4$, $MgF_2$, and $SnO_2$.

On a reflective layer and/or an optically transparent layer and the like, a protective layer can be formed using a thermoplastic resin and/or thermosetting resin. First, a thermoplastic resin and/or a thermosetting resin are dissolved in a suitable solvent to prepare a coating solution. Then, the coating solution is coated to a reflective layer and/or an optically transparent layer and dried to thereby form a protective layer.

A protective layer using an ultraviolet curable resin can be formed by directly coating an ultraviolet curable resin to a reflective layer and/or an optically transparent layer or dissolving an ultraviolet curable resin in a suitable solvent to prepare a coating solution and coating the coating solution to a reflective layer and/or an optically transparent layer, and then irradiating ultraviolet ray to the coating solution to harden it.

For ultraviolet curable resins, for example, acrylate resins such as urethane acrylates, epoxy acrylates, and polyester acrylates can be used.

Each of these materials may be used alone and in combination with two or more and may be formed in not only a single layer but also in a multi-layered structure.

For a method for forming a protective layer, coating methods such as spin-coating and casting, sputtering, chemical vapor deposition, and the like are used, of which spin-coating is preferable.

The thickness of the protective layer is typically 0.1μm to 100μm, however it is preferably 3μm to 30μm in the present invention.

Further, a substrate may be disposed on the surface of a reflective layer or an optically transparent layer. The reflective layer and the optically transparent layer may be arranged so as to face each other. Two sheets of optical recording media may be laminated after arranging a reflective layer and an optically transparent layer so as to face each other.

In addition, an ultraviolet curable resin layer, an inorganic resin layer or the like may be formed on a mirror surface side of a substrate to protect the surface and/or to prevent dust or the like from attaching thereto.

An optically transparent layer or a cover layer should be formed when a lens with a high numerical aperture is used for higher recording density. With increasing numeral aperture, the portion through which the reproducing light passes must have a reduced thickness. This is because the allowance in the aberration occurs when the perpendicular direction to the surface of the medium deviates from the optical axis of an optical pickup, the deviation angle so called a tilt angle is reduced with increasing numerical aperture. The tilt angle is in proportional to the square of the product of reciprocal of the wavelength of an optical source multiplied by the numerical aperture of the objective lens and is susceptible to the aberration due to the thickness of the substrate. To reduce the aberration due to the thickness of the substrate, the thickness of the substrate is reduced.

For this purpose, some optical recording media are presented, for example, an optical recording medium in which a substrate, a recording layer with concave convex or irregularities formed thereon, a reflective layer, and an optically transparent layer or a cover layer which is a layer transmitting light are disposed in this order in a laminar structure, in which the reproducing light is irradiated from the optically transparent layer to reproduce information in the recording layer. Another example is an optical recording medium in which a reflective layer, a recording layer, and an optically transparent layer or a cover layer having optical transparency are disposed in this order on a substrate, in which the reproducing light is irradiated from the optically transparent layer to reproduce information in the recording layer.

These optical recording media can allow the use of an objective lens with a high numerical aperture by reducing the thickness of the optically transparent layer. Namely, higher-density recording can be performed by recording and/or reproducing information on a medium having a thin optically transparent layer, in which the reproducing light is irradiated from the optically transparent layer.

The cover layer may typically comprise a polycarbonate sheet or an ultraviolet curable resin. The cover layer used herein may include a binder layer for binding the cover layer to an adjacent layer.

Hereinafter, a sputtering target suitably used for the optical recording medium of this invention having a recording layer which comprises Bi, Fe, and oxygen, and the production method will be disclosed in detail.

A sputtering target according to the present invention comprises Bi, Fe, and O. The sputtering target is suitably used for forming a recording layer of an optical recording medium which performs recording and reproducing with a laser beam at wavelengths of 550nm or less.

The relationship between extinction coefficient k which is one of optical constants and is a coefficient representing a light absorption degree and wavelength of light was examined. When the value of k is zero, it represents that there is no absorption of light, and with increasing value of k, absorption light increases. A recording layer formed using the sputtering target of the present invention which comprises Bi, Fe, and O has absorption light of nearly zero at a wavelength of 600nm or more, and has approx. zero value of k, therefore, it is hard to record information. However, the value of k abruptly becomes greater at wavelengths shorter than 550nm and excellent recording is enabled. Particularly, in the vicinity of a wavelength of 400nm, absorption of light becomes substantially greater, fairly excellent properties are exhibited as a recording layer of an optical recording medium.

The sputtering target of the present invention preferably comprises a Bi oxide and a Fe oxide or a complex oxide of Bi and Fe. The sputtering target may comprise a complex oxide of Bi and Fe and further comprises one or more selected from a Bi oxide and a Fe oxide. There may be cases where a Bi oxide or a Fe oxide remains in a sputtering target without making complex of Bi and Fe in a well-balanced condition, depending on the composition. An aspect of the sputtering target comprises a Bi oxide and a Fe oxide, or another aspect of the sputtering target comprises a complex oxide of Bi and Fe, or still another aspect of a sputtering target comprises a complex oxide of Bi and Fe and further comprises one or more selected from a Bi oxide and a Fe oxide. In any of the aspects stated above, an optical recording medium produced using such a sputtering target as stated above exhibits excellent properties. In particular, by including a Bi oxide as a constituent of a recording layer, the produced recording layer can include the Bi oxide. Since a recorded mark can be excellently recorded by precipitating Bi metal, it is remarkably effective to use a sputtering target which comprises a Bi oxide.

The sputtering target of the present invention preferably comprises one or more selected from a Bi oxide, a Fe oxide, and a complex oxide of Bi and Fe, and the oxide is preferably an oxide having a smaller amount of oxygen compared to the stoichiometric composition. Examples of the oxide which is a Bi oxide, a Fe oxide, or a complex oxide of Bi and Fe and has a smaller amount of oxygen compared to the stoichiometric composition include BiOx ($x < 1.5$), FeOx ($x < 1.5$), BiFeOx ($x < 3$), $Bi_{25}FeOx$ ($x < 40$), and $Bi_{36}Fe_2Ox$ ($x < 57$). By reducing an amount of oxygen to enhance metallic properties, sputtering is enabled through the use of a direct-current power (DC power). DC sputtering has advantages in that apparatuses used for the manufacturing are cheaper than those used in RF sputtering and the apparatuses used in DC sputtering are to be more downsized than those used in RF sputtering. When a layer is formed by DC sputtering, the amount of oxygen in the layer can be controlled by externally introducing oxygen. By employing DC sputtering, recording properties are easily controlled.

A sputtering target having a smaller amount of oxygen compared to the stoichiometric composition is calcined after a Bi metal and $Fe_2O_3$ being mixed. It is also possible to produce a target having a small amount of oxygen by the methods such as by reducing the amount of oxygen remaining in the target by controlling the temperature.

The sputtering target of the present invention preferably comprises one or more selected from $BiFeO_3$, $Bi_{25}FeO_{40}$, and $Bi_{36}Fe_2O_{57}$ as the principal constituent. As mentioned above, an optical recording medium using a recording layer which comprises Bi, Fe, and oxygen exhibits excellent recording properties. There have been a sputtering target containing Bi, Fe, and oxygen for magnetic optical recording and having a garnet structure, however, such sputtering target do not comprise the compounds used in the present invention as the principal constituent from the perspective of the composition for forming a garnet structure. A sputtering target which comprises three elements of Bi, Fe, and oxygen has not been used so far, because it is impossible to form a garnet structure only with these three elements. In addition, the present invention does not relate to magnetic optical recording media, and the present invention relates a sputtering target used for forming a layer which primarily comprises Bi, Fe, and oxygen, which is hereafter referred to as a BiFeO layer, for an optical recording medium without using magnetism, particularly for a write-once-read-many optical recording medium capable of high-density recording.

The sputtering target preferably consists of three elements of Bi, Fe, and oxygen.

In this case, the sputtering target may comprise impure elements other than the three elements, however, it is not preferred to include the microelements that would impair properties of layers.

A sputtering target of the present invention is produced by mixing and calcining powder of oxides of raw

materials. It is possible to produce the sputtering target using calcine powder of a Bi oxide and powder of a Fe oxide. It is also possible to produce a sputtering target by producing powder of a compound which primarily comprises three elements of Bi, Fe, and oxygen and then calcining the powder. As the calcining method, press-heat calcination processes such as hot-pressing, hot isostatic pressuring or HIP may be used. For calcination temperatures, higher temperatures are preferred to reinforce the strength of a sputtering target, however, in the case of a compound which comprises three elements of Bi, Fe, and oxygen, separation of the phase and/or fusion occur at a temperature of approx. 800°C or more, and it is difficult to uniformly calcine it. Then, the calcination temperature must be controlled not so as to be more than approx. 750°C.

In particular, an optical recording medium in which a BiFeO layer is formed using a sputtering target which comprises one or more selected from $BiFeO_3$, $Bi_{25}FeO_{40}$, and $Bi_{36}Fe_2O_{57}$ as the principal constituent for the recording layer exhibits excellent properties. The presence of $BiFeO_3$, $Bi_{25}FeO_{40}$, and $Bi_{36}Fe_2O_{57}$ can be checked by means of X-ray diffraction. For the radiation source, Cu is used to measure it with the angle of 2θ of an X-ray diffractometer from 5° to 60°. The term the principal constituent means that the highest content or the highest % by mass is contained in a compound. Typically, a material exhibiting the highest diffraction peak as a result of an X-ray diffraction analysis can be determined as the principal constituent, however, the content may not be in proportion to the scale of diffraction peak. The case of a sputtering target which comprises two or more elements selected from $BiFeO_3$, $Bi_{25}FeO_{40}$, and $Bi_{36}Fe_2O_{57}$ as the principal constituent means that each content of these two or more compounds is same and the content of these two or more compounds is higher than that of other components.

The sputtering target preferably comprises $Bi_2O_3$ and/or $Fe_2O_3$. An optical recording medium with a BiFeO layer formed using a sputtering target which comprises these compounds for the recording layer exhibits excellent properties. The presence of $Bi_2O_3$ and/or $Fe_2O_3$ can be checked by means of X-ray diffraction. For the radiation source, Cu is used to measure it at an angle of 2θ from 5° to 60°.

In the X-ray diffraction analysis for identifying constituents of $BiFeO_3$, $Bi_{25}FeO_{40}$, $Bi_{36}Fe_2O_{57}$, and $Bi_2O_3$, and $Fe_2O_3$, when the angle of 2θ where a diffraction peak is expected to be detected is defined as θ1, a substance actually having a diffraction peak within the range of $\theta1 \pm 1$ degree is determined to be included in the above-noted compounds.

In X-ray diffraction analysis, the lattice constant varies, and misalignments are developed in angles at which diffraction peaks appear depending on causes such as measurement temperature, internal stress of the layer, X-ray wavelength error of measurement, and shift of composition. For well-known substances, at what angles diffraction peaks are detected can be known through the use of ASTM (American Society for Testing and Material) cards and JCPDS search. When a sample is analyzed to identify the component, ASTM cards and JCPDS card charts are widely used. The term, JCPDS stands for Joint Committee on Powder Diffraction Standards, and it is a chart of X-ray diffraction patterns distributed by the organization called International Center for Diffraction Data, and a number of charts of diffraction patterns of standard substances are stored for search. An X-ray diffraction pattern chart of a sample having unknown components is compared to the charts of standard substances, and to what chart of standard substance the X-ray diffraction pattern chart corresponds or is closely related is determined. With this comparison, the substance of the sample is identified. The identification method using JCPDS card charts is a method widely used in the world, as shown in X-ray Diffraction Analysis Rules, and descriptions of X-ray Diffraction Analysis Rules in Japanese Industrial Standard (JIS) as well as in X-ray Diffraction Analysis - Ceramics Basic Structures 3 edited by Tokyo Institute of Technology. In the measurement, to what chart of standard substance the X-ray diffraction pattern of the substance having unknown components corresponds or is closely related is examined, and then the substance is identified.

$$n\lambda = 2d \sin\theta$$

In the above equation, n represents a positive integral number, λ represents a wavelength, d represents distance of lattice plane, and θ represents a glancing angle or a supplementary angle of incident angle.

Since the Bragg principle is approved, a peak of diffraction also appears at the positions where n represents an integral multiple at the side of higher-angle of 2θ. The identification of substances is enabled by analyzing peaks of positions represented by integral multiple at the same time of the analysis of diffraction peaks based on 2θ. As described above, in X-ray diffraction analysis, lattice constant varies, and misalignments are developed in angles at which diffraction peaks appear due to measurement temperature, internal stress of the layer, X-ray wavelength error of measurement, shift of composition, and the like, therefore, when a substance having a peak near at the angle where a diffraction peak appeared at a known substance, it can be determined that the substance corresponds to the known substance having that diffraction peak.

For the misalignment of diffraction peak, for example, peaks having 2θ = 22.491 degree sought from the standard chart of $BiFeO_3$ (reference code 20-0169) was studied. The results of measurement on four sputtering targets produced in the same manner and under same conditions were respectively observed. The degree 2θ of the standard

data of $BiFeO_3$ is 22.491°. On the other hand, these targets showed very slight misalignments of 22.380°, 22.500°, 22.420°, and 22.420°, respectively. This study showed that the misalignments of approx. ± 1 degree are within the error range of measurement, when repeatedly measured. Therefore, even though such misalignments in angle of ± 1 degree diffraction peak are observed, it can be identified as a known peak. For example, when a substance having a peak with a misalignment of ± 1 degree from 22.491°, it can be determined that the $BiFeO_3$ described in the present invention are included in the substance. The sputtering target which comprises Bi, Fe, and O and has a diffraction peak at 22.380 $\leq 2\theta \leq$ 22.500 is particularly effective in recording properties.

Similarly, according to the standard data of $Bi_{36}Fe_2O_{57}$, $Bi_{36}Fe_2O_{57}$ has a peak at $2\theta$ = 27.681 degree. The above-noted four targets were measured, and it was found that they had a peak at 27.65°, 27.64°, 27.76°, and 27.67°.

According to the standard data of $Bi_{25}FeO_{40}$, it has a peak at 20 = 27.683 degree. These four targets were measured, and it was found that they had a peak at 27.66°, 27.64°, 27.76°, and 27.68°, respectively.

Since misalignments of approx. ± 1 degree are caused in the repeated measurements, it is considered that the misalignments of ± 1 degree in $2\theta$ of any of these substances fall under the error range of measurement.

Preferably, the sputtering target does not further comprise $Bi_2Fe_4O_9$. With increasing content of Bi, the content of $Bi_2Fe_4O_9$ tends to lower. The presence of $Bi_2Fe_4O_9$ can be checked by means of X-ray diffraction. For the radiation source, Cu is used to measure it with the angle of 28 of an X-ray diffractometer from 5° to 60°. It is found that an optical recording medium with a BiFeO layer formed for a recording layer using a sputtering target in which the presence of $Bi_2Fe_4O_9$ is recognized by means of X-ray diffraction does not satisfactorily exhibit recording properties and does not suit high-density recording.

The sputtering target preferably has a content of Co, Ca and Cr less than the detection limit. When a sputtering target which comprises impurities is used, a formed layer also comprises elements of impurities. In optical recording, recording is performed by absorbing laser beam irradiation into a recording layer to elevate the temperature at the recording layer and to induce physical or chemical changes. The term physical or chemical changes means changes such as crystallization or the like. A layer used for a recording layer containing impurities is not preferably used because crystallization temperature varies, and the size of crystal differs at the time of crystallization.

For detection of impurities, the composition is quantitatively analyzed by means of the inductively coupled plasma emission spectrometry. This analysis is suitable when analyzing element in minute amount, and even when using this analysis, the sputtering target preferably has a content of Co, Ca and Cr less than the detection limit.

The sputtering target preferably has a packing density of 65% to 96%.

The higher the packing density of the sputtering target is, the higher the strength of the target is, and the time for forming a layer tends to be shortened because of its high-density elements, at the same time, the difference in composition between the target and the formed layer tends to increase. There may be cases where the composition of the target can be close to that of the layer by reducing the density of the target, however, a density-reduced target causes problems with not only delayed layer-forming speed but also causes a problem that the target itself goes brittle to be broken when forming a layer. Herein, the term packing density represents a value obtained as density by comparing the weight of a target actually produced to the weight of the target calculated when the weight of the target is dominated by an intended substance at 100%.

Table 1 shows packing densities of a target, conditions of the target during the time for forming a layer or after the forming, and recording properties of a recording medium with a layer formed therein when using a $Bi_{10}Fe_5Ox$ target having a diameter of 76.2mm and a thickness of 4mm. When the packing density was 50% or less, the target was not able to be formed as a sputtering target even after calcinations. With a packing density of 61%, the target was able to be formed, however, it was easily broken immediately after applying an electric power of 100W. With a packing density of 98%, the density was so high and the target was so hard that it was easily broken. With a packing density of 65% to 96%, the target was able to be formed with no problem, and excellent recording properties were exhibited. Even with a packing density of 61% and 98%, excellent recording properties were obtained by forming a layer under the conditions ensuring no occurrence of fracture of target in forming a layer. As can be seen from the above results, the packing density of the sputtering target is preferably 65% to 96%.

Table 1

| Packing Density (%) | Conditions of Target | Recording Properties |
|---|---|---|
| 50% or less | A target cannot be formed | |
| 61% | Easily damaged by applying radiofrequency power of 100W. Damaged at 50W. | Excellent |
| 65% | Possible to form a sputtering target by applying radiofrequency power of 100W. | Excellent |

(continued)

| Packing Density (%) | Conditions of Target | Recording Properties |
|---|---|---|
| 83% | Possible to form a sputtering target by applying radiofrequency power of 100W. | Excellent |
| 96% | Possible to form a sputtering target by applying radiofrequency power of 100W. | Excellent |
| 98% | Easily damaged by applying radiofrequency power of 100W. Damaged at 50W. | Excellent |

The sputtering target preferably has an atomic ratio of Bi to Fe satisfying the relation of Bi/Fe ≥ 0.8. An optical recording medium having a BiFeO-layer formed using the target exhibits excellent properties and is particularly suitable for high-density recording.

Theoretically, the upper limit of the ratio Bi/Fe is 25 based on the assumption that a sputtering target which comprises $Bi_{25}FeO_{40}$ as the principal constituent is used, however, virtually, it is 15 or so. A sputtering target production method of the present invention relates to a method for producing the BiFeO target of the present invention by calcining powder of $Bi_2O_3$ and $Fe_2O_3$. $Bi_2O_3$ naturally exists as an oxide of Bi, and $Fe_2O_3$ exists as an oxide of Fe. These powers are crushed by a dry process or a wet process and then classifying into a uniformly sized particle diameter. Next, the powders are mixed, heated, and pressed to put into shape and then calcined at a maintained temperature of 750°C in the atmosphere. The strength of a sputtering target can be improved by repeatedly performing the process of re-crushing a calcined target and forming the shape by heating and pressing. A sputtering target can be obtained by bonding the target calcined as above to a backing plate made from oxygen-free copper by means of metal bonding or resin bonding.

The present invention also proposes an optical recording medium which comprises a BiFeO layer formed using the sputtering target of the present invention. In the optical recording medium, necessary layers are formed on a resin substrate which comprises a polycarbonate or the like. Grooves and pits may be formed on the resin substrate for controlling tracking or the like. A BiFeO-layer is formed by applying radiofrequency power while introducing an argon gas in vacuo. Besides, a metallic layer and a protective layer for improving properties may be disposed as a reflective layer.

The above paragraphs describe the sputtering target of the present invention with a focus on optical recording media, and the application of the sputtering target of the present invention is not limited to optical recording media and may be used for other purposes, as long as performance of the layer meets requirements. For example, the sputtering target can be used for forming a thin layer made from magnetic materials, for forming a thin-layer for producing an isolator for optical controlling, and for forming a thin layer for an optical switch.

For a rough production line of forming the sputtering target, it is possible to take procedure steps of weighing of raw materials, mixing by a dry-process ball mill, hot-pressing, shape forming, and bonding can be used. It is also usable to take the procedure steps of weighing of raw materials, mixing by a dry-process ball mill, spray-drying, hot-pressing, shape forming, and bonding.

According to the present invention, it is possible to present a write-once-read-many recording medium capable of recording small recording marks at higher degrees of modulated amplitudes with stability. With the use of the additional elements that have not been found so far, it is possible to provide a write-once-read-many optical recording medium having excellent recording and reproducing properties and reliabilities.

Further, the present invention can provide a sputtering target suitable for arbitrarily forming a layer having a stable composition and structure, the production method thereof, and can also provide a high-density optical recording medium using the target.

Hereinafter, the present invention will be described in detail on an optical recording medium which comprises a recording layer in which a material of the present invention represented by BiOx ($0 < x < 1.5$) is used and a write-once-read-many optical recording medium which comprises Bi, M and oxygen as constituent elements of a recording layer, referring to specific examples, however, the present invention is not limited to the disclosed examples.

Example A-1

On a polycarbonate-substrate with a guide groove having a groove depth of 21nm formed thereon, a layer having the composition represented by BiOx ($0 < x < 1.5$) and a thickness of 10nm was formed by sputtering to yield a write-once-read-many optical recording medium of the present invention. This layer was formed at a radiofrequency power of 100W and an Ar gas flow rate of 40sccm using a sputtering target having the composition of $Bi_2O_3$ and a diameter of 76.2mm.

Recording was performed to the optical recording medium under the following conditions using an optical disk

evaluation system DDU-1000 manufactured by PULSTEC INDUSTRIAL CO., LTD. having a lens numerical aperture of 0.65 at a wavelength of 405nm.

- Modulation Mode: 1-7 modulation
- Recording linear density: The shortest mark length (2T) = 0.231μm
- Recording linear velocity: 6.0m/s
- Waveform equalization: Normal equalizer

As a result, an excellent jitter value of 9.9% was obtained in a consecutively recorded portion at a recording power of 5.2mW, and excellent binary recording properties having a modulated amplitude of 55% were realized.

Example A-2

A write-once-read-many recording medium of the present invention was produced by sputtering a layer which comprises Fe and O, having a thickness of 10nm on a polycarbonate-substrate with a guide groove having a groove depth of 21nm formed thereon. This layer was formed at a radiofrequency power of 100W and an Ar gas flow rate of 40sccm using a sputtering target having the composition of $Bi_{10}Fe_5O_x$. and a diameter of 76.2mm. The target was prepared by calcining a mixture of $Bi_2O_3$ and $Fe_2O_3$ at a ratio of 2:1. Theoretically it should have been $Bi_{10}Fe_5O_{22.5}$, however, the amount of oxygen was unable to be measured with accuracy because of leaked oxygen in a calcination process, and therefore the oxygen is represented by $O_x$.

The optical recording medium was evaluated under the following conditions using an optical disk evaluation system DDU-1000 manufactured by PULSTEC INDUSTRIAL CO., LTD. having a lens numerical aperture of 0.65 at a wavelength of 405nm.

- Modulation Mode: 1-7 modulation
- Recording linear density: The shortest mark length (2T) = 0.231μm
- Recording linear velocity: 6.0m/s
- Waveform equalization: Normal equalizer

As a result, an excellent jitter value of 8.9% was obtained in a consecutively recorded portion at a recording power of 5.8mW, and excellent binary recording properties having a modulated amplitude of 52% were realized.

Example A-3

Reflection EELS measurements were performed using a write-once-read-many optical recording medium produced and used for recording in Example A-1. A scanning Auger electron spectrometer PHI4300 manufactured by Perkin-Elmer was modified for the measurements. EELS stands for Electron Energy Loss Spectroscopy and is a spectroscopy system in which electrons are irradiated to a sample to measure an energy distribution of electrons scattered by interaction with the outer surface of the sample. When a primary electron of certain energy excites the inner shell of an atom to be measured, an electron of certain energy is discharged, resulting in the scattering of the primary electron. During this process, some energy is lost by the interaction with the neighboring atoms. Therefore, by examining the way the electrons are scattered, information such as radial distribution function of neighboring atoms can be obtained.

The radial distribution function in the vicinity of an oxygen atom was measured based on the EELS spectrum obtained by EELS measurements. A radial distribution function represents a probability of existence of electron in the vicinity of an atom and enables calculations and presumptions of the valence and structure of the atom. Among analysis software packages based on the photoelectron multiple scattering theory, the FEFF software published by Washington University are widely used. The number of valences and structure thereof can be presumed by using this analysis software and referring the calculated values against actually measured values.

FIG. 1 illustrates values of radial distribution function measured by the method as stated above.

FIG. 2 shows radial distribution functions calculated using an FEFF. The diagram shows radial distribution functions respectively in the case of Bi-trivalent which could be taken by Bi; the case of Bi-trivalent however taking a structure of $\beta$-$Bi_2O_3$; and the case of $BiO_2$ of Bi-tetravalence.

Comparing these radial distribution functions, peaks 1011 and 1012 in the vicinity of 6 angstrom in the recorded portion are distinctively shown. When comparing the two diagrams, the peaks 1011 and 1012 match each other. It proves that $BiO_2$, i.e. $BiO_2$ of tetravalent Bi exists in the recorded portion.

A write-once-read-many optical recording medium having such a recording mark enables excellent recording

with higher modulated amplitudes and realizing high-density recording.

Hereinafter, the present invention will be further described in detail on a write-once-read-many optical recording medium using the element L used in the present invention as an additional element, referring to Examples and Comparative Examples, however, the present invention is not limited to the disclosed examples.

(Examples B-1 to B-18)

A write-once-read-many optical recording medium was produced by taking a structure in which a polyolefin-substrate (ZEONOR manufactured by NIPPON ZEON CO., LTD.); a recording layer which comprises bismuth as the principal constituent of the elements constituting the recording layer and a Bi oxide; a heat-insulating layer; and a reflective layer were formed in a laminar structure, and using the following materials for these respective layers.

A sputtering target was produced using raw materials in which $Bi_2O_3$ and oxides of the element shown in Table 2 were mixed at a ratio from 2:1 to 5:1, and then a recording layer was formed using this sputtering target so as to have a thickness approx. 7nm.

Table 2 shows resulting respective Pauling's electronegativity values of each element L added to the respective recording layer, and the standard enthalpy values of formation $\Delta H_f^0$ of oxides of the element L, however, these values are based on the definitions of the present invention. When the Pauling's electronegativity value is 1.80 or more, the standard enthalpy of formation $\Delta H_f^0$ of oxides of the element L is not important, and thus some elements in Table 2 have not their values of $\Delta H_f^0$.

As described above, in the present invention, Pauling's electronegativity values and standard enthalpy values of oxide-formation of an element L were obtained with each valence fixed to each element group. The individual valences of the individual elements based on the definitions of the present invention are also written in Table 2.

In Table 2, the term type A represents an element L which falls under the definition (I) of the present invention, and the term type B represents an element L which falls under the definition (II) of the present invention.

A material in which ZnS-SiO2 was used for a heat-insulating layer at a ratio of 85:15 (mol%) and formed so as to have a thickness of 15nm.

For a reflective layer, an Ag alloy was used and formed so as to have a thickness of 100nm.

The track pitch of a polyolefin substrate was 0.437μm and the thickness was 0.6mm.

Recording was performed to these optical recording media under the following conditions using an optical disk evaluation system DDU-1000 manufactured by PULSTEC INDUSTRIAL CO., LTD. having a lens numerical aperture of 0.65 at a wavelength of 405nm.

As a result, extremely excellent recording and reproducing properties, i.e. jitter values shown in Table 2 were realized.

< Recording and Reproducing Conditions >

- Modulation Mode: 1-7 modulation
- Recording linear density: The shortest mark length (2T) = 0.204μm
- Recording linear velocity: 6.6m/s
- Waveform equalization: Limit equalizer
- Reproducing power: 0.5mW

Next, these write-once-read-many optical recording media were left under the conditions at a temperature of 80°C and a relative humidity of 85% for 100 hours to measure the amount of change in jitter value. The amount of change in jitter value is calculated as follows:

$$\text{(Jitter value after a storage test)} - \text{(Initial jitter value)}$$

Table 2 shows the results.

As is clear from Table 2, the elements satisfying the definition (I) for the element L of the present invention respectively demonstrated an excellent initial jitter value and a small degree of degradation in jitter value, suffering from the storage test.

It was also demonstrated that the standard enthalpy of formation of oxides "$\Delta H_f^0$" may take any values, as long as the definition (I) is satisfied.

Also, the elements satisfying the definition (II) for the element L of the present invention respectively demonstrated an excellent initial jitter value and a small degree of degradation in jitter value suffering from the storage test.

Table 2

| Sample No. | Element L | Valence | Pauling Electro-negativity | Standard Enthalpy of formation $\Delta H_f^0$ (kJ $mol^{-1}$) | Type | Initial jitter value (%) | Amount of change in jitter value (%) |
|---|---|---|---|---|---|---|---|
| 1 | B | 3 | 2.04 | -1,273 | A | 5.6 | 0.5 |
| 2 | P | 3 | 2.19 | | A | 6.2 | 0.5 |
| 3 | Ga | 3 | 1.81 | -1,819 | A | 6.2 | 0.5 |
| 4 | Se | 2 | 2.55 | | A | 6.3 | 0.5 |
| 5 | Pd | 2 | 2.20 | -85 | A | 5.8 | 0.2 |
| 6 | Ag | 1 | 1.93 | | A | 6.1 | 0.3 |
| 7 | Sb | 3 | 2.05 | -1,440 | A | 5.7 | 0.4 |
| 8 | Te | 2 | 2.10 | | A | 5.7 | 0.4 |
| 9 | W | 2 | 2.36 | | A | 5.9 | 0.5 |
| 10 | Pt | 2 | 2.28 | | A | 6.0 | 0.3 |
| 11 | Au | 1 | 2.54 | | A | 6.2 | 0.3 |
| 12 | Cd | 2 | 1.69 | -258 | B | 6.2 | 0.5 |
| 13 | As | 3 | 2.18 | -1,313 | A | 6.3 | 0.5 |
| 14 | Re | 2 | 1.90 | | A | 6.0 | 0.5 |
| 15 | Os | 2 | 2.20 | | A | 6.0 | 0.5 |
| 16 | Ir | 2 | 2.20 | | A | 6.0 | 0.5 |
| 17 | Tl | 3 | 2.04 | -394 | A | 6.2 | 0.6 |
| 18 | Hg | 2 | 2.00 | -90 | A | 6.3 | 0.6 |

In the Examples above, the wavelength for recording and reproducing was set at 405nm, however, recording was also excellently performed with a jitter value of 9% or less for a laser beam at a wavelength of 660nm by adjusting the thickness of a heat-insulation layer from 15nm to 120nm. In the test, the track pitch of the substrate was 0.74μm, and the recording and reproducing conditions were based on those of DVD+R. The amount of increased jitter value obtained in the same storage test as the Examples above gave results substantially similar to those shown in Table 2.

(Comparative Example B-1)

A write-once-read-many optical recording medium was produced in the same manner as Example B-1, provided that the principal constituent is bismuth, and a recording layer formed by sputtering through the use of a metallic bismuth target was used instead of the recording layer containing a Bi oxide. The optical recording medium was then evaluated.

The analysis by X-ray photoelectron spectroscopy showed that no bismuth oxide was detected in the recording layer except in the interface between the substrate and the recording layer and the interface between the recording layer and ZnS-$SiO_2$. Thus, it proved that the recording layer produced in Comparative Example B-1 did not include a Bi oxide.

As a result of the measurements of recording and reproducing properties, the initial jitter value exceeded 15%, and it was impossible to measure jitter after the storage test.

From the results, the importance of a recording layer which comprises not only bismuth as the principal constituent but also a Bi oxide is confirmed.

(Example B-19)

On a polycarbonate substrate with a guide groove having a groove depth of 50nm and a track pitch of 0.40μm formed thereon, a $ZnS-SiO_2$ layer, i.e. an under coating layer having a thickness of 65nm and a BiPdO layer, i.e. a recording layer having a thickness of 15nm were disposed in this order in a laminar structure by sputtering. The atomic number ratio of Bi to Pd, or Bi:Pd was approx. 3:1.

Next, on the recording layer, an organic-material layer, i.e. an upper coating layer which comprises a pigment or a dye represented by the following Chemical Formula 1 was formed by spin-coating so as to have the average thickness of approx. 30nm. On the organic-material layer, a reflective layer which comprises Ag, having a thickness of 150nm was disposed by sputtering, and then a protective layer made from an ultraviolet curable resin having a thickness of 5μm was further disposed on the reflective layer by spin-coating so as to thereby yield a write-once-read-many recording medium of the present invention.

A pigment or a dye represented by Chemical Formula 1 is typically used for materials of conventional DVD±R, and such materials respectively have little absorption in blue-laser wavelengths.

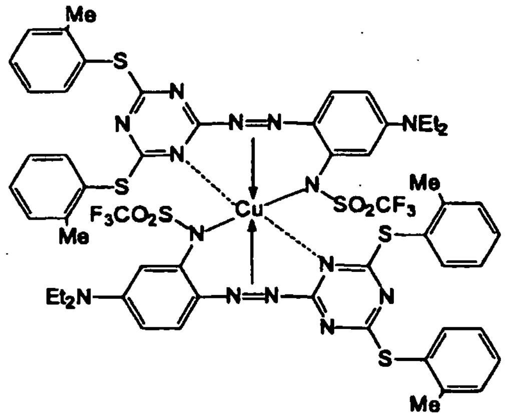

Chemical Formula 1

Recording and reproducing were performed to the optical recording medium under the recording and reproducing conditions in accordance with HD and DVD-R to evaluate it using an optical disk evaluation system DDU-10 having a numerical aperture of 0.65 manufactured by PULSTEC INDUSTRIAL CO., LTD. at a wavelength of 405nm..

The measurement of the optical recording medium resulted in an excellent value of PRSNR 22 at a recording power of 5.8mW, and excellent recording and reproducing properties were achieved.

(Example B-20)

On a polycarbonate substrate with a guide groove having a groove depth of 20nm and a track pitch of 0.32μm formed thereon, a reflective layer made from Ag having a thickness of 100nm, a $ZnS-SiO_2$ layer, i.e. an upper coating layer having a thickness of 16nm and a BiPdO layer or a recording layer having a thickness of 7nm were disposed in this order in a laminar structure by sputtering. The atomic number ratio of Bi to Pd, or Bi:Pd was approx. 3:1.

Next, a cover layer made from a resin having a thickness of 0.1mm was laminated on the recording layer to yield a write-once-read-many recording medium of the present invention.

Recording and reproducing were performed to the optical recording medium under the recording and reproducing conditions in accordance with BD-R to evaluate it using an optical disk evaluation system having a numerical aperture of 0.85 manufactured by PULSTEC INDUSTRIAL CO., LTD. at a wavelength of 405nm..

The measurement of the optical recording medium resulted in an excellent jitter value of 6.0% at a recording power of 7.0mW, and excellent recording and reproducing properties were achieved.

(Example B-21)

A write-once-read-many optical recording medium of the present invention was produced in the same manner as Example B-19, provided that a BiBO layer was used for the recording layer. The write-once-read-many optical recording medium was then evaluated. The atomic number ratio of Bi to B, or Bi:B was approx. 2:1.
The measurement of the optical recording medium resulted in an excellent value of PRSNR 23 at a recording power of 5.6mW, and it exemplified that excellent recording and reproducing properties are realizable with the optical recording medium.

(Example B-22)

A write-once-read-many optical recording medium of the present invention was produced in the same manner as Example B-20, provided that a BiBO layer was used for the recording layer. The write-once-read-many optical recording medium was then evaluated. The atomic number ratio of Bi to B, or Bi:B was approx.. 2:1.
The measurement of the optical recording medium resulted in an excellent jitter value of 5.9% at a recording power of 6.7mW, and excellent recording and reproducing properties were achieved.

(Example B-23)

On a polycarbonate substrate with a guide groove having a groove depth of 50nm and a track pitch of 0.32μm formed thereon, a reflective layer made from Ag having a thickness of 100nm was formed by sputtering, an organic-material layer, i.e. an upper coating layer which comprises a pigment or a dye represented by Chemical Formula 1 was formed by spin-coating so as to have the average thickness of approx. 30nm, then a BiBO layer, i.e. a recording layer having a thickness of 15nm, and a ZnS-SiO2 layer, i.e. an under coating layer were disposed in this order in a laminar structure by sputtering. The atomic number ratio of Bi to B, or Bi:B was approx. 2:1.
Next, a cover layer made from a transparent resin having a thickness of 100nm was laminated on the recording layer to thereby yield a write-once-read-many recording medium of the present invention.
Recording and reproducing were performed to the optical recording medium under the recording and reproducing conditions in accordance with BD-R to evaluate it using an optical disk evaluation system having a numerical aperture of 0.85 manufactured by PULSTEC INDUSTRIAL CO., LTD. at a wavelength of 405nm..
The measurement of the optical recording medium resulted in an excellent jitter value of 6.5% at a recording power of 4.8mW, and excellent recording and reproducing properties were achieved.

(Example B-24)

On a polycarbonate substrate with a guide groove having a groove depth of 40nm and a track pitch of 0.74μm formed thereon, a BiBO layer, i.e. a recording layer having a thickness of 15nm and a ZnS-$SiO_2$ layer, i.e. an upper coating layer having a thickness of 40nm were disposed in this order in a laminar structure by sputtering. The atomic number ratio of Bi to B, or Bi:B was approx.. 2:1.
Next, on the recording layer, a reflective layer made from Ag having a thickness of 100nm and a protective layer made from an ultraviolet curable resin having a thickness of approx. 5μm were disposed to thereby yield a write-once-read-many recording medium of the present invention.
Recording and reproducing were performed to the optical recording medium under the recording and reproducing conditions in accordance with DVD+R to evaluate it using an optical disk evaluation system DDU-1000 having a numerical aperture of 0.65 manufactured by PULSTEC INDUSTRIAL CO., LTD. at a wavelength of 660nm.
The measurement of the optical recording medium resulted in a jitter value of 7.2% at a recording power of 12.0 m W, and excellent recording and reproducing properties were achieved.

(Example B-25)

A write-once-read-many optical recording medium of the present invention was produced in the same manner as Example B-24, provided that Sb was added to the materials of the recording layer. The write-once-read-many optical recording medium was then evaluated. The atomic number ratio of Bi to Sb, or Bi:Sb was approx.. 4:1.
The measurement of the optical recording medium resulted in a jitter value of 7.6% at a recording power of 10.0mW, and excellent recording and reproducing properties were achieved.

(Example B-26)

On a polycarbonate substrate with a guide groove having a groove depth of 20nm and a track pitch of 0.437μm formed thereon, a BiPdO layer, i.e. a recording layer having a thickness of 5nm and a $ZnS-SiO_2$ layer, i.e. an upper coating layer having a thickness of 15nm were disposed in this order in a laminar structure by sputtering. On the $ZnS-SiO_2$ layer, a reflective layer which comprises Ag, having a thickness of 100nm was disposed by sputtering, and a protective layer which comprises an ultraviolet curable resin, having a thickness of approx. 5μm was further disposed by spin-coating to thereby yield a write-once-read-many optical recording medium of the present invention.

In Example B-26, the atomic number ratio of the total amount of Pd to bismuth was changed in the recording layer to evaluate jitter value. The recording and reproducing conditions were same as those in Examples B-1 to B-18.

The measurement of the optical recording medium, as shown in FIG. 3, exemplified that an excellent jitter value can be obtained in the range where the atomic number ratio of the total amount of Pd relative to bismuth is 1.25 or less. The value 1.25 is represented by the dotted-line in FIG. 3. In addition, it was exemplified that the elements defined in the present invention except for Pd respectively have a tendency similar to the above.

Next, the present invention relating to the sputtering target will be specifically described referring to examples and comparative examples, however, the present invention is not limited to the disclosed examples.

Example C-1

Powders of $BI_2O_3$ and $Fe_2O_3$ were mixed so that the atomic ratio of Bi to Fe was 6:5 and then mixed in a ball mill by dry-process for 1 hour. The mixed powder was formed by pressing at 100MPa to 200MPa and then calcined at 750°C for 5 hours in the atmosphere to yield a sputtering target. The target had a diameter of 152.4φ and a thickness of 4mm. The target was bounded to a backing plate made from oxygen-free copper by metal bonding to yield a sputtering target 1. The sputtering target had a packing density of 75%.

X-ray diffraction pattern of the sputtering target was measured. The measurement conditions are as shown in Table 3. FIG. 4 shows the measurement results.

To identify diffraction peak positions obtained in the measurement, the diffraction peak positions were searched and checked against those of known substances. The diagram marked with (a) at the top of FIG. 4 represents the diffraction pattern of target 1. The diagram marked with (b) represents diffraction peak positions of $BiFeO_3$ which are based on known data. In X-ray diffraction analysis, data on the position of diffraction lines and on the intensities of substances have been compiled in a database from the source of data on X-ray diffraction measured in the past. Therefore, the measured substance can be identified by comparing the measured diffraction result with the previous data. As a result of a search after comparing $BiFeO_3$ data marked with (b) with the measured data marked with (a), it was found that diffraction peaks with a mark "°" were those of $BiFeO_3$. Similarly, the diagram marked with (c) is the known data of $Fe_2O_3$, and the diagram marked with (d) is the known data of $Bi_2O_3$. Similarly, diffraction peaks of $Bi_2O_3$ and $Fe_2O_3$ were identified. The greatest peak was the one corresponding to $BiFe_2O_3$, and this demonstrated that this compound is the principal component. Further, the sputtering target was subjected to the ICP analysis, i.e. the inductively coupled plasma emission spectrometry. Part of the sputtering target was dissolved in an aqua regia as a sample and then diluted with superpure water for the analysis. For the solution, elements of Co, Ca, and Cr were respectively analyzed. The result of analysis was that the content of the respective elements was less than the detection limit.

Table 3

| | |
|---|---|
| Source | Cu |
| Wavelength | 1.54056 angstrom |
| Monochromator | used |
| Tube current | 100mA |
| X-ray tube voltage | 40kV |
| Covered data | 5 to 60 deg |
| Scanning axis | 2θ/θ |
| Sampling interval | 0.020 deg |
| Scanning speed | 8.000 deg/min |
| Divergence slit | 1.00 deg |
| Scattering slit | 1.00 deg |

(continued)

| Source | Cu |
|---|---|
| Photo detection slit | 0.15mm |

Example C-2

An optical recording medium was produced using the sputtering target prepared in Example C-1.

On a polycarbonate substrate with a guide groove having a groove depth of 50nm and a track pitch of 0.44μm formed thereon, a BiFeO layer having a thickness of 15nm was formed by sputtering, an organic-material layer containing a pigment or a dye represented by the following Chemical Formula 1 was formed on the BiFeO layer by spin-coating so as to have the average thickness of approx. 30nm, a reflective layer made from Ag having a thickness of 150nm was disposed on the organic-material layer by sputtering, and then a protective layer made from an ultraviolet curable resin having a thickness of approx. 5μm was further disposed on the reflective layer by spin-coating to thereby yield a write-once-read-many recording medium of the present invention. A pigment or a dye represented by Chemical Formula 1 is typically used for materials of conventional DVD±R, and such materials respectively have little absorption in blue-laser wavelengths.

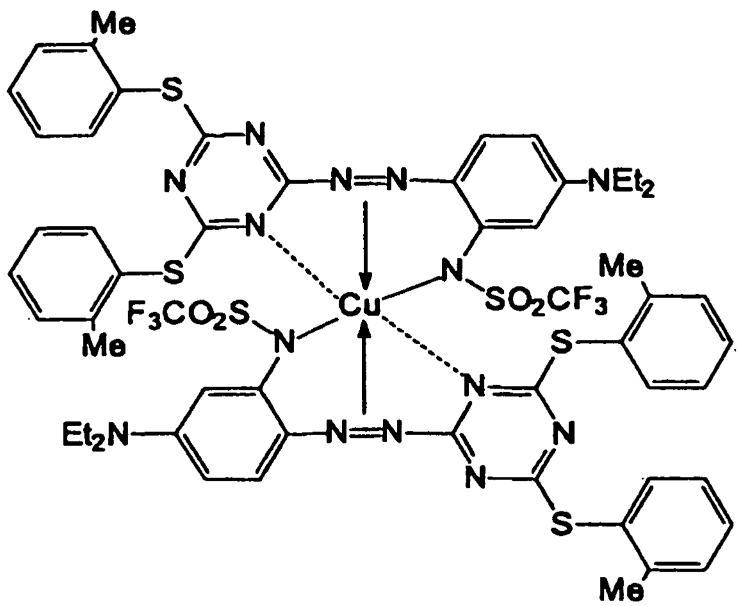

Chemical Formula 1

Binary recording was performed to the optical recording medium under the following conditions using an optical disk evaluation system DDU-1000 having a numerical aperture of 0.65 manufactured by PULSTEC INDUSTRIAL CO., LTD. at a wavelength of 405nm.

< Recording Conditions >

- Modulation Mode: 8-16 modulation
- Recording linear density: 1T = 0.0917μm The shortest mark length (3T) = 0.275μm
- Recording linear velocity: 6.0m/s
- Waveform equalization: Normal equalizer

As a result, as shown in FIG. 5, an excellent jitter value of 10.2% was obtained at a recording power of 6.1mW,

and excellent recording properties were realized.

Example C-3

Sputtering target 2 was prepared in the same manner as Example C-1, provided that powders of $Bi_2O_3$ and $Fe_2O_3$ were mixed so that the atomic ratio of Bi to Fe was 35:5. The sputtering target had a packing density of 67%.
X-ray diffraction pattern of the sputtering target was measured. The measurement conditions were as shown in Table 3. FIG. 6 shows the measurement result.
To identify diffraction peak positions obtained in the measurement, the diffraction peak positions were referred to those of known substances. As shown in FIG. 6, most if not all peaks of the diffraction pattern matched to those of $Bi_{25}FeO_{40}$. As a matter of course, the highest peak was that of $Bi_{25}FeO_{40}$, and it proves that this compound was the principal constituent.

Example C-4

An optical recording medium was produced using the sputtering target prepared in Example C-3.
On a polycarbonate substrate with a guide groove having a groove depth of 50nm and a track pitch of 0.44μm formed thereon, a ZnS-SiO2 layer having a thickness of 50nm and a BiFeO layer having a thickness of 15nm were formed in this order in a laminar structure by sputtering, an organic-material layer containing a pigment or a dye represented by the following Chemical Formula 1 was formed on the BiFeO layer by spin-coating so as to have the average thickness of approx. 30nm, a reflective layer which comprises Ag, having a thickness of 150nm was disposed on the organic-material layer by sputtering, and then a protective layer made from an ultraviolet curable resin having a thickness of approx. 5μm was further disposed on the reflective layer by spin-coating to thereby yield a write-once-read-many recording medium. A pigment or a dye represented by Chemical Formula 1 is typically used for materials of conventional DVD±R, and such materials respectively have little absorption in blue-laser wavelengths.
Binary recording was performed to the optical recording medium under the following conditions using an optical disk evaluation system DDU-1000 having a numerical aperture of 0.65 manufactured by PULSTEC INDUSTRIAL CO., LTD. at a wavelength of 405nm.

< Recording Conditions >

- Modulation Mode: 8-16 modulation
- Recording linear density: 1T = 0.0917μm The shortest mark length (3T) = 0.275μm
- Recording linear velocity: 6.0m/s
- Waveform equalization: Normal equalizer

As a result, as shown in FIG. 7, an excellent jitter value of 8.6% was obtained at a recording power of 7.0mW, and excellent recording properties were realized.
Even when the recording power exceeded the optimum recording power, a write-once-read-many optical recording medium having a high modulated amplitude and a wide range of recording power margin was enabled without a great change in reproducing signal level or RF level of the recorded portions.

Example C-5

Sputtering target 3 was obtained in the same manner as Example C-1, provided that powders of $Bi_2O_3$ and $Fe_2O_3$ were mixed so that the atomic ratio of Bi to Fe was 1:5. The target had a packing density of 67%.
X-ray diffraction pattern of the sputtering target was measured. The measurement conditions are as shown in Table 3. FIG. 8 shows the measurement result.
To identify diffraction peak positions obtained in the measurement, the diffraction peak positions were searched and checked against those of known substances. As a result, it was found that the sputtering target had diffraction peaks corresponding to those of $Bi_2Fe_4O_9$, $Bi_2O_3$, and $Fe_2O_3$, however, the other diffraction peaks of the sputtering target did not match to those of known substances. The greatest peak was the one corresponding to $Fe_2O_3$, and this demonstrated that this compound was the principal constituent.

Example C-6

An optical recording medium was produced using the sputtering target prepared in Example C-5.

On a polycarbonate substrate with a guide groove having a groove depth of 50nm and a track pitch of 0.44μm formed thereon, a $ZnS-SiO_2$ layer having a thickness of 50nm and a BiFeO layer having a thickness of 10nm were disposed in this order in a laminar structure by sputtering, an organic-material layer containing a pigment or a dye represented by Chemical Formula 1 was formed on the BiFeO layer by spin-coating so as to have the average thickness of approx. 30nm, a reflective layer made from Ag having a thickness of 150nm was disposed on the organic-material layer by sputtering, and then a protective layer which comprises an ultraviolet curable resin, having a thickness of approx. 5μm was further disposed on the reflective layer by spin-coating to thereby yield a write-once-read-many recording medium. A pigment or a dye represented by Chemical Formula 1 is typically used for materials of conventional DVD±R, and such materials respectively have little absorption in blue-laser wavelengths.

Binary recording was performed to the optical recording medium under the following conditions using an optical disk evaluation system DDU-1000 having a numerical aperture of 0.65 manufactured by PULSTEC INDUSTRIAL CO., LTD. at a wavelength of 405nm.

< Recording Conditions >

- Modulation Mode: 8-16 modulation
- Recording linear density: 1T = 0.0917μm The shortest mark length (3T) = 0.275μm
- Recording linear velocity: 6.0m/s
- Waveform equalization: Normal equalizer

The recording resulted in a degraded jitter value of 22.6% at a recording power of 8.1mW.

Further, the thickness of the BiFeO layer was changed to 15nm and 20nm respectively, however, the resulting jitter values were further worsened, and the measurement was impossible.

Example C-7

Sputtering target 4 was obtained in the same manner as Example C-1, provided that the powders of $Bi_2O_3$ and $Fe_2O_3$ were mixed so that the atomic ratio of Bi to Fe was 4:5. Sputtering target 4 has a packing density of 77%.

X-ray diffraction pattern of the sputtering target was measured. The measurement conditions are as shown in Table 3. FIG. 9 shows the measurement results.

The diffraction pattern obtained in the measurement is shown at (a) in FIG. 9. Diffraction peak positions of the sputtering target were referred to those of known substances of (b) $BiFeO_3$ and (c) $Bi_2Fe_4O_9$. The search result showed that the sputtering target had only diffraction peaks corresponding to those of $BiFeO_3$ and $Bi_2Fe_4O_9$. The greatest peak was the one corresponding to $BiFe_2O_3$, and this demonstrated that this compound was the principal constituent.

Example C-8

An optical recording medium was produced using the sputtering target prepared in Example C-7.

On a polycarbonate substrate with a guide groove having a groove depth of 50nm and a track pitch of 0.44μm formed thereon, a $ZnS-SiO_2$ layer having a thickness of 50nm and a BiFeO layer having a thickness of 10nm were disposed in this order in a laminar structure by sputtering, an organic-material layer containing a pigment or a dye represented by Chemical Formula 1 was formed on the BiFeO layer by spin-coating so as to have the average thickness of approx. 30nm, a reflective layer made from Ag having a thickness of 150nm was disposed on the organic-material layer by sputtering, and then a protective layer made from an ultraviolet curable resin having a thickness of approx. 5μm was further disposed on the reflective layer by spin-coating to thereby yield a write-once-read-many recording medium. A pigment or a dye represented by Chemical Formula 1 is typically used for materials of conventional DVD±R, and such materials respectively have little absorption in blue-laser wavelengths.

Binary recording was performed to the optical recording medium under the following conditions using an optical disk evaluation system DDU-1000 having a numerical aperture of 0.65 manufactured by PULSTEC INDUSTRIAL CO., LTD. at a wavelength of 405nm. The shortest mark length was set at 0.205pm to examine the capability of high density recording.

< Recording Conditions >

- Modulation Mode: 1-7 modulation
- Recording linear density: The shortest mark length (2T) = 0.205μm
- Recording linear velocity: 6.0m/s
- Waveform equalization: Normal equalizer

FIG. 10 shows the result.

Example C-9

An optical recording medium was produced in the same manner as Example C-8 using a sputtering target prepared in the same manner as Example C-7, provided the atomic ratio of Bi to Fe was changed to prepare the sputtering target. The optical recording was measured under the same recording conditions as Examples. FIG. 10 shows the measurement result. As shown in FIG. 10, an optical recording medium using a sputtering target having an atomic ratio represented by $Bi/Fe \geq 0.8$, i.e. the sputtering target having an atomic ratio of $Bi/(Bi + Fe) \geq 4/9$ in FIG. 10, demonstrated a jitter value of approx. 14%, and it was demonstrated that an excellent jitter value can be obtained even at high density recording. The jitter value was substantially improved even with an optical recording medium using a sputtering target having an atomic ratio represented by $Bi/(Bi + Fe) \geq 3/8$, and it turned out to be effective.

Example C-10

Sputtering target 5 was prepared in the same manner as Example C-1, provided that powders of $Bi_2O_3$ and $Fe_2O_3$ were mixed so that the atomic ratio of Bi to Fe was 10:5. The target had a packing density of 85%.

X-ray diffraction pattern of the sputtering target was measured. The measurement conditions are as shown in Table 3. FIG. 11 shows the measurement result.

To identify diffraction peak positions of the diffraction pattern (a) obtained in the measurement, the diffraction peak positions were referred to those of known substances (b) to (e). As a result, there were diffraction peaks corresponding to those of $Bi_{25}FeO_{40}$, $BiFeO_3$, $Bi_2O_3$, and $Fe_2O_3$, however, the other diffraction peaks of the sputtering target did not match to those of other substance. The greatest peak was the one corresponding to $Bi_{25}FeO_{40}$, and this demonstrated that this was the principal constituent.

The sputtering target was subjected to the ICP analysis, i.e. inductively coupled plasma-atomic emission spectroscopy. Part of the sputtering target was dissolved in an aqua regia as a sample and then diluted with superpure water for the analysis. Elements of Co, Ca, and Cr were respectively analyzed for the solution. The result of analysis was that the content of the respective elements was less than the detection limit.

In addition, sputtering target 6 in which 0.003% by mass of Al and 0.001% by mass of Co had been detected as impurity was prepared in the same manner as above.

Example C-11

Optical recording media were prepared using the sputtering targets 5 and 6 prepared in Example C-10, respectively.

On a polycarbonate substrate with a guide groove having a groove depth of 50nm and a track pitch of 0.44μm formed thereon, a $ZnS\text{-}SiO_2$ layer having a thickness of 50nm and a BiFeO layer having a thickness of 15nm were disposed in this order in a laminar structure by sputtering, an organic-material layer containing a pigment or a dye represented by Chemical Formula 1 was formed on the BiFeO layer by spin-coating so as to have the average thickness of approx. 30nm, a reflective layer made from Ag having a thickness of 150nm was disposed on the organic-material layer by sputtering, and then a protective layer made from an ultraviolet curable resin having a thickness of approx. 5μm was further disposed on the reflective layer by spin-coating to thereby yield a write-once-read-many recording medium. A pigment or a dye represented by Chemical Formula 1 is typically used for materials of conventional DVD±R, and such materials respectively have little absorption in blue-laser wavelengths.

Binary recording was performed to the optical recording media under the following conditions using an optical disk evaluation system DDU-1000 having a numerical aperture of 0.65 manufactured by PULSTEC INDUSTRIAL CO., LTD. at a wavelength of 405nm.

< Recording Conditions >

- Modulation Mode: 8-16 modulation
- Recording linear density: 1T = 0.0917μm The shortest mark length 3T = 0.275μm
- Recording linear velocity: 6.0m/s
- Waveform equalization: Normal equalizer

As a result, excellent jitter values were obtained. Specifically, the optical recording medium using target 5 had a jitter value of 8.4% at a recording power of 5.0 m W, and the optical recording medium using target 6 had a jitter value of 8.2% at a recording power of 5.0mW, and both optical recording media achieved excellent recording properties.

Even when the recording power exceeded the optimum recording power, a write-once-read-many optical recording medium having a high modulated amplitude and a wide range of recording power margin was enabled without a great change in reproducing signal level or RF level of the recorded portions.

Example C-12

Sputtering target 7 was obtained in the same manner as Example C-1, provided that powders of $Bi_2O_3$ and $Fe_2O_3$ were mixed so that the atomic ratio of Bi to Fe was 10:5. The sputtering target had a packing density of 71%.

X-ray diffraction pattern of the sputtering target was measured. The measurement conditions are as shown in table 3. FIG.12 shows the measurement result.

To identify diffraction peak positions obtained in the measurement, the diffraction peak positions were referred to those of known substances. The diagram marked with (a) represents the diffraction pattern of target 7, and the diagram marked with (b) represents the diffraction pattern with known data of $Bi_{36}Fe_2O_{57}$. The diagram marked with (c) shows known data of $BiFeO_3$, and the diagram marked with (d) shows known data of $Fe_2O_3$. The greatest peak was the one corresponding to $Bi_{36}Fe_2O_{57}$, and this demonstrated that this compound was the principal constituent.

Example C-13

An optical recording medium was produced using the sputtering target prepared in Example C-12.

On a polycarbonate substrate with a guide groove having a groove depth of 21nm and a track pitch of 0.44μm formed thereon, a BiFeO layer having a thickness of 5nm, a $ZnS-SiO_2$ layer having a thickness of 14nm, and a reflective layer made from Ag having a thickness of 100nm were disposed in this order in a laminar structure by sputtering. On the reflective layer, a protective layer made from an ultraviolet curable resin having a thickness of approx. 5μm was disposed by spin-coating to yield a write-once-read-many optical recording medium.

Binary recording was performed to the optical recording medium under the following conditions using an optical disk evaluation system DDU-1000 having a numerical aperture of 0.65 manufactured by PULSTEC INDUSTRIAL CO., LTD. at a wavelength of 405nm.

< Recording Conditions >

- Modulation Mode: 8-16 modulation
- Recording linear density: 1T = 0.0917μm The shortest mark length 3T = 0.275μm
- Recording linear velocity: 6.0m/s
- Waveform equalization: Normal equalizer

As a result, an excellent jitter value of 6.2% was obtained at a recording power of 10.1mW, and excellent recording properties were enabled by the write-once-read-many optical recording medium.

Example C-14

Sputtering target 8 was obtained in the same manner as Example C-1, provided that powders of $Bi_2O_3$ and Fe were mixed so that the atomic ratio of Bi to Fe was 35:5. The sputtering target had a packing density of 69%.

X-ray diffraction pattern of the sputtering target was measured, and very slight peaks of Bi and Fe were observed, and it was clarified that a compound corresponding to $Bi_{25}FeO_{40}$ or a compound corresponding to $Bi_{36}Fe_2O5_7$ was the

principal constituent.

Example C-15

An optical recording medium was produced using the sputtering target prepared in Example C-14.

On a polycarbonate substrate with a guide groove having a groove depth of 50nm and a track pitch of 0.44μm formed thereon, a ZnS-$SiO_2$ layer having a thickness of 20nm and a BiFeO layer having a thickness of 13nm were disposed in this order in a laminar structure by sputtering. The BiFeO layer was formed with introducing oxygen thereto at a flow rate of 2% relative to Ar at the same time. On the BiFeO layer, a ZnS-$SiO_2$ layer having a thickness of 20nm was formed, and an Al-alloy reflective layer having a thickness of 100nm was formed on the ZnS-$SiO_2$ layer by sputtering, and a protective layer made from an ultraviolet curable resin having a thickness of approx. 5μm was further disposed on the Al-alloy reflective layer by spin-coating to yield a write-once-read-many optical recording medium.

Binary recording was performed to the write-once-read-many optical recording medium under the following conditions using an optical disk evaluation system DDU-1000 having a numerical aperture of 0.65 manufactured by PULSTEC INDUSTRIAL CO., LTD. at a wavelength of 405nm.

< Recording Conditions >

- Modulation Mode: 8-16 modulation
- Recording linear density: 1T = 0.0917μm The shortest mark length 3T = 0.275μm
- Recording linear velocity: 6.0m/s
- Waveform equalization: Normal equalizer

As a result, an excellent jitter value of 7.6% was obtained at a recording power of 9.0mW, and excellent recording properties were enabled by the write-once-read-many optical recording medium.

It was possible to achieve a write-once-read-many optical recording medium having a high modulated amplitude and a wider recording power margin without great changes in reproducing signal level or RF level even when the recording power exceeded the optimum recording power.

Example C-16

For a sputtering target of $Bi_{10}Fe_5O_x$, four targets thereof were produced in the same manner. X-ray diffraction patterns of these sputtering targets were measured. Table 4 shows the values of 2θ of the diffraction peaks of these $Bi_{10}Fe_5Ox$ targets detected as a result of the measurement. Targets having such a peak at those angles of 2θ shown in Table 4 can be presented as examples of the sputtering target of the present invention.

Table 4

| Target 1 | Target 2 | Target 3 | Target 4 |
|---|---|---|---|
| 21.34 | 21.40 | 21.32 | 21.32 |
| 22.42 | 22.50 | 22.38 | 22.40 |
| 24.72 | 24.80 | 24.66 | 24.70 |
| 27.68 | 27.76 | 37.64 | 27.66 |
| 30.38 | 28.98 | 28.18 | 28.86 |
| 32.08 | 30.46 | 28.84 | 30.36 |
| 32.88 | 32.16 | 30.34 | 32.06 |
| 35.26 | 32.96 | 32.04 | 32.86 |
| 37.46 | 35.30 | 32.84 | 35.22 |
| 38.94 | 37.52 | 35.20 | 35.64 |
| 39.52 | 39.04 | 35.68 | 37.44 |
| 41.58 | 39.58 | 37.42 | 38.94 |

(continued)

| Target 1 | Target 2 | Target 3 | Target 4 |
|---|---|---|---|
| 43.50 | 41.64 | 38.92 | 39.48 |
| 45.38 | 43.58 | 39.46 | 41.56 |
| 45.76 | 45.46 | 41.54 | 43.50 |
| 48.98 | 45.84 | 43.48 | 45.38 |
| 51.30 | 49.02 | 45.34 | 45.74 |
| 51.74 | 51.40 | 45.74 | 46.96 |
| 52.34 | 51.82 | 48.92 | 48.92 |
| 53.98 | 52.42 | 51.28 | 51.30 |
| 55.58 | 54.06 | 51.72 | 51.74 |
| 56.34 | 55.66 | 52.30 | 52.32 |
| 56.96 | 56.44 | 53.94 | 53.96 |
| 58.72 | 57.16 | 55.54 | 55.58 |
| | 58.82 | 56.32 | 56.34 |
| | | 57.10 | 57.10 |
| | | 58.68 | 58.68 |

## Claims

**1.** A write-once-read-many optical recording medium comprising:

a substrate,
a recording layer, and
a reflective layer,
wherein information is recorded to the recording layer by forming a recording mark, and
wherein the recording layer comprises a material represented by BiOx ($0<x<1.5$),
**characterized in that** the recording mark comprises tetravalent Bi in form of a crystal of Bi oxide, and the unrecorded portion is amorphous.

**2.** A write-once-read-many optical recording medium comprising:

a substrate,
a recording layer, and
a reflective layer,
wherein information is recorded to the recording layer by forming a recording mark,
wherein the recording layer comprises Bi, O, and M as constituent elements, and
wherein M represents at least one element selected from the group consisting of Mg, Al, Cr, Mn, Co, Fe, Cu, Zn, Li, Si, Ge, Zr, Ti, Hf, Sn, Mo, V, Nb, Y, and Ta,
**characterized in that** the recording mark comprises crystal of the one or more elements contained in the recording layer, tetravalent Bi in form of a crystal of Bi oxide and crystal of an oxide of M.

**3.** The optical recording medium according to claim 2, wherein the atomic number ratio of the total amount of the element M to bismuth is 1.25 or less.

**4.** The optical recording medium according to claim 2, wherein the optical recording medium has any one of laminar structures of a laminar structure in which at least the recording layer, an upper coating layer, and the reflective layer are disposed on the substrate in this order, and a laminar structure in which at least the reflective layer, an upper coating layer, the recording layer, and a cover layer are disposed on the substrate in this order.

5. The optical recording medium according to claim 2, wherein the optical recording medium is produced using a sputtering target which comprises one or more selected from $BiFeO_3$, $Bi_{25}FeO_{40}$, and $Bi_{36}Fe_2O_{57}$.

6. A write-once-read-many optical recording medium comprising:

a substrate,
a recording layer, and
a reflective layer,
wherein the recording layer comprises Bi, O, and L as constituent elements, and the recording layer comprises a Bi oxide, and
wherein L represents at least one element selected from the group consisting of B, P, As, Se, Tc, Pd, Ag, Sb, Te, W, Re, Os, Ir, Pt, Au, Hg, Tl, Po, At, and Cd.

7. The optical recording medium according to claim 6, wherein the element L represents at least one element selected from the group consisting of B, P, Se, Pd, Ag, Sb, Te, W, Pt, and Au.

8. The optical recording medium according to claim 6, wherein the atomic number ratio of the total amount of the element L to bismuth is 1.25 or less.

9. The optical recording medium according to claim 6, wherein the optical recording medium further comprises an upper coating layer and has a laminar structure in which the recording layer, the upper coating layer, and the reflective layer are disposed on the substrate in this order.

10. The optical recording medium according to claim 9, wherein the optical recording medium further comprises an under coating layer and has a laminar structure in which the under coating layer, the recording layer, the upper coating layer, and the reflective layer are disposed on the substrate in this order.

11. The optical recording medium according to claim 6, wherein the optical recording medium further comprises an upper coating layer and a cover layer and has a laminar structure in which the reflective layer, the upper coating layer, the recording layer, and the cover layer are disposed on the substrate in this order.

12. The optical recording medium according to claim 11, wherein the optical recording medium further comprises an under coating layer and has a laminar structure in which the reflective layer, the upper coating layer, the recording layer, the under coating layer, and the cover layer are disposed on the substrate in this order.

13. The optical recording medium according to claim 6, wherein the optical recording medium further comprises at least one of an under coating layer and an upper coating layer, and at least any one of the under coating layer and the upper coating layer comprises ZnS and/or $SiO_2$.

14. The optical recording medium according to claim 6, wherein the optical recording medium further comprises at least one of an under coating layer and an upper coating layer, and at least any one of the under coating layer and the upper coating layer comprises an organic material.

15. Use of a sputtering target **characterized in that** the sputtering target comprises Bi, Fe, and O, for forming a recording layer in the write-once-read-many optical recording medium according to claim 2.

16. Use according to claim 15, wherein the sputtering target consists of Bi, Fe, and O.

17. Use according to any one of claims 15 to 16, wherein the sputtering target comprises a Bi oxide and a Fe oxide, or comprises a complex oxide of Bi and Fe.

18. Use according to claim 17, wherein the sputtering target comprises the complex oxide of Bi and Fe and further comprises one or more selected from the Bi oxide and the Fe oxide.

19. Use according to claim 15, wherein the sputtering target comprises one or more selected from a Bi oxide, a Fe oxide, and a complex oxide of Bi and Fe, and the oxide is an oxide having a smaller amount of oxygen compared to the stoichiometric composition.

20. Use according to any one of claims 15 to 19, wherein the sputtering target comprises one or more selected from $BiFeO_3$, $Bi_{25}FeO_{40}$, and $Bi_{36}Fe_2O_{57}$.

21. Use according to any one of claims 15 to 20, wherein the sputtering target comprises $Bi_2O_3$ and/or $Fe_2O_3$.

22. Use according to any one of claims 15 to 21, wherein the sputtering target does not comprise $Bi_2Fe_4O_9$.

23. Use according to any one of claims 15 to 22, wherein the content of Co, Ca, and Cr is less than the detection limit of the inductively coupled plasma emission spectrometry.

24. Use according to any one of claims 15 to 23, wherein the sputtering target has a packing density of 65% to 96%.

25. Use according to any one of claims 15 to 24, wherein the atomic ratio of Bi and Fe satisfies the requirement of $Bi/Fe \geq 0.8$.

26. A method comprising:

calcining powders of $Bi_2O_3$ and $Fe_2O_3$ only to produce a sputtering target and using said sputtering target according to any one of claims 15 to 25.

## Patentansprüche

1. Einmal beschreibbares, mehrmals lesbares optisches Aufzeichnungsmedium umfassend:

ein Substrat,
eine Aufzeichnungsschicht und
eine Reflexionsschicht,
wobei Information durch Erzeugen einer Aufzeichnungsmarkierung in der Aufzeichnungsschicht aufgezeichnet wird, und
wobei die Aufzeichnungsschicht ein durch BiOx ($0<x<1{,}5$) wiedergegebenes Material umfasst,
**dadurch gekennzeichnet, dass** die Aufzeichnungsmarkierung vierwertiges Bi in Form eines Kristalls von Bi-Oxid umfasst und der nicht aufgezeichnete Bereich amorph ist.

2. Einmal beschreibbares, mehrmals lesbares optisches Aufzeichnungsmedium umfassend:

ein Substrat,
eine Aufzeichnungsschicht und
eine Reflexionsschicht,
wobei Information durch Erzeugen einer Aufzeichnungsmarkierung in der Aufzeichnungsschicht aufgezeichnet wird,
wobei die Aufzeichnungsschicht Bi, O und M als konstituierende Elemente umfasst, und
wobei M mindestens ein Element ausgewählt aus der Gruppe bestehend aus Mg, Al, Cr, Mn, Co, Fe, Cu, Zn, Li, Si, Ge, Zr, Ti, Hf, Sn, Mo, V, Nb, Y und Ta darstellt,
**dadurch gekennzeichnet, dass** die Aufzeichnungsmarkierung Kristalle von dem einen oder mehreren in der Aufzeichnungsschicht enthaltenen Elementen, vierwertiges Bi in Form eines Kristalls von Bi-Oxid und Kristalle von einem Oxid von M umfasst.

3. Optisches Aufzeichnungsmedium gemäß Anspruch 2, wobei das Atomzahlverhältnis der Gesamtmenge des Elementes M zu Bismut 1,25 oder weniger beträgt.

4. Optisches Aufzeichnungsmedium gemäß Anspruch 2, wobei das optische Aufzeichnungsmedium irgendeine Schichtstruktur aus einer Schichtstruktur, bei welcher mindestens die Aufzeichnungsschicht, eine obere Beschichtungsschicht und die Reflexionsschicht in dieser Reihenfolge auf dem Substrat angeordnet sind, und einer Schichtstruktur, bei welcher mindestens die Reflexionsschicht, eine obere Beschichtungsschicht, die Aufzeichnungsschicht und eine Deckschicht in dieser Reihenfolge auf dem Substrat angeordnet sind umfasst.

5. Optisches Aufzeichnungsmedium gemäß Anspruch 2, wobei das optische Aufzeichnungsmedium unter Verwendung

eines Sputtertargets hergestellt worden ist, welches eines oder mehrere ausgewählt aus $BiFeO_3$, $Bi_{25}FeO_{40}$ und $Bi_{36}Fe_2O_{57}$ umfasst.

**6.** Einmal beschreibbares, mehrmals lesbares optisches Aufzeichnungsmedium umfassend:

ein Substrat,
eine Aufzeichnungsschicht und
eine Reflexionsschicht,
wobei die Aufzeichnungsschicht Bi, O und L als konstituierende Elemente umfasst und die Aufzeichnungsschicht ein Bi-Oxid umfasst, und
wobei L mindestens ein Element ausgewählt aus der Gruppe bestehend aus B, P, As, Se, Tc, Pd, Ag, Sb, Te, W, Re, Os, Ir, Pt, Au, Hg, Tl, Po, At und Cd darstellt.

**7.** Optisches Aufzeichnungsmedium gemäß Anspruch 6, wobei das Element L mindestens ein Element ausgewählt aus der Gruppe bestehend aus B, P, Se, Pd, Ag, Sb, Te, W, Pt und Au darstellt.

**8.** Optisches Aufzeichnungsmedium gemäß Anspruch 6, wobei das Atomzahlverhältnis der Gesamtmenge des Elementes L zu Bismut 1,25 oder weniger beträgt.

**9.** Optisches Aufzeichnungsmedium gemäß Anspruch 6, wobei das optische Aufzeichnungsmedium ferner eine obere Beschichtungsschicht umfasst und eine Schichtstruktur hat, bei welcher die Aufzeichnungsschicht, die obere Beschichtungsschicht und die Reflexionsschicht in dieser Reihenfolge auf dem Substrat angeordnet sind.

**10.** Optisches Aufzeichnungsmedium gemäß Anspruch 9, wobei das optische Aufzeichnungsmedium ferner eine untere Beschichtungsschicht umfasst und eine Schichtstruktur hat, bei welcher die untere Beschichtungsschicht, die Aufzeichnungsschicht, die obere Beschichtungsschicht und die Reflexionsschicht in dieser Reihenfolge auf dem Substrat angeordnet sind.

**11.** Optisches Aufzeichnungsmedium gemäß Anspruch 6, wobei das optische Aufzeichnungsmedium ferner eine obere Beschichtungsschicht und eine Deckschicht umfasst und eine Schichtstruktur hat, bei welcher die Reflexionsschicht, die obere Beschichtungsschicht, die Aufzeichnungsschicht, und die Deckschicht in dieser Reihenfolge auf dem Substrat angeordnet sind.

**12.** Optisches Aufzeichnungsmedium gemäß Anspruch 11, wobei das optische Aufzeichnungsmedium ferner eine untere Beschichtungsschicht umfasst und eine Schichtstruktur hat, bei welcher die Reflexionsschicht, die obere Beschichtungsschicht, die Aufzeichnungsschicht, die untere Beschichtungsschicht und die Deckschicht in dieser Reihenfolge auf dem Substrat angeordnet sind.

**13.** Optisches Aufzeichnungsmedium gemäß Anspruch 6, wobei das optische Aufzeichnungsmedium ferner mindestens eine aus einer unteren Beschichtungsschicht und einer oberen Beschichtungsschicht umfasst und mindestens irgendeine aus der unteren Beschichtungsschicht und der oberen Beschichtungsschicht ZnS und/oder $SiO_2$ umfasst.

**14.** Optisches Aufzeichnungsmedium gemäß Anspruch 6, wobei das optische Aufzeichnungsmedium ferner mindestens eine aus einer unteren Beschichtungsschicht und einer oberen Beschichtungsschicht umfasst und mindestens irgendeine aus der unteren Beschichtungsschicht und der oberen Beschichtungsschicht ein organisches Material umfasst.

**15.** Verwendung eines Sputtertargets, **dadurch gekennzeichnet, dass** das Sputtertarget Bi, Fe und O umfasst, zum Erzeugen einer Aufzeichnungsschicht in dem einmal beschreibbaren, mehrmals lesbaren optischen Aufzeichnungsmedium gemäß Anspruch 2.

**16.** Verwendung gemäß Anspruch 15, wobei das Sputtertarget aus Bi, Fe und O besteht.

**17.** Verwendung gemäß irgendeinem der Ansprüche 15 bis 16, wobei das Sputtertarget ein Bi-Oxid und ein Fe-Oxid umfasst oder ein komplexes Oxid von Bi und Fe umfasst.

**18.** Verwendung gemäß Anspruch 17, wobei das Sputtertarget das komplexe Oxid von Bi und Fe umfasst und ferner eines oder mehr ausgewählt aus dem Bi-Oxid und dem Fe-Oxid umfasst.

**19.** Verwendung gemäß Anspruch 15, wobei das Sputtertarget eines oder mehr ausgewählt aus einem Bi-Oxid, einem Fe-Oxid und einem komplexen Oxid von Bi und Fe umfasst, und das Oxid ein Oxid ist, das verglichen mit der stöchiometrischen Zusammensetzung eine kleinere Menge an Sauerstoff aufweist.

**20.** Verwendung gemäß irgendeinem der Ansprüche 15 bis 19, wobei das Sputtertarget eines oder mehr ausgewählt aus $BiFeO_3$, $Bi_{25}FeO_{40}$ und $Bi_{36}Fe_2O_{57}$ umfasst.

**21.** Verwendung gemäß irgendeinem der Ansprüche 15 bis 20, wobei das Sputtertarget $Bi_2O_3$ und/oder $Fe_2O_3$ umfasst.

**22.** Verwendung gemäß irgendeinem der Ansprüche 15 bis 21, wobei das Sputtertarget nicht $Bi_2Fe_4O_9$ umfasst.

**23.** Verwendung gemäß irgendeinem der Ansprüche 15 bis 22, wobei der Gehalt von Co, Ca und Cr kleiner ist als die Nachweisgrenze der induktiv gekoppelten Plasma-Emissionsspektroskopie.

**24.** Verwendung gemäß irgendeinem der Ansprüche 15 bis 23, wobei das Sputtertarget eine Packungsdichte von 65% bis 96% hat.

**25.** Verwendung gemäß irgendeinem der Ansprüche 15 bis 24, wobei das Atomverhältnis von Bi und Fe die Beziehung $Bi/Fe \geq 0{,}8$ erfüllt.

**26.** Verfahren umfassend:

Calcinieren von Pulvern aus lediglich $Bi_2O_3$ und $Fe_2O_3$, um ein Sputtertarget herzustellen, und Verwenden des Sputtertargets gemäß irgendeinem der Ansprüche 15 bis 25.

## Revendications

**1.** Support d'enregistrement optique à enregistrement unique et lectures multiples comprenant :

un substrat,
une couche d'enregistrement, et
une couche réfléchissante,
où l'information est enregistrée dans la couche d'enregistrement par la formation d'une marque d'enregistrement, et
où la couche d'enregistrement comprend un matériau représenté par BiOx ($0 < x < 1{,}5$),
**caractérisé en ce que** la marque d'enregistrement comprend Bi tétravalent sous forme d'un cristal d'oxyde de Bi, et la partie non enregistrée est amorphe.

**2.** Support d'enregistrement optique à enregistrement unique et lectures multiples comprenant :

un substrat,
une couche d'enregistrement, et
une couche réfléchissante,
où l'information est enregistrée dans la couche d'enregistrement par la formation d'une marque d'enregistrement,
où la couche d'enregistrement comprend Bi, 0 et M comme éléments constitutifs, et
où M représente au moins un élément choisi dans le groupe consistant en Mg, Al, Cr, Mn, Co, Fe, Cu, Zn, Li, Si, Ge, Zr, Ti, Hf, Sn, Mo, V, Nb, Y et Ta,
**caractérisé en ce que** la marque d'enregistrement comprend un cristal du un ou plusieurs éléments contenus dans la couche d'enregistrement, Bi tétravalent sous forme d'un cristal d'oxyde de Bi et un cristal d'un oxyde de M.

**3.** Support d'enregistrement optique selon la revendication 2, où le rapport en nombres d'atomes de la quantité totale de l'élément M au bismuth est 1,25 ou moins.

**4.** Support d'enregistrement optique selon la revendication 2, où le support d'enregistrement optique a l'une quelconque des structures lamellaires d'une structure lamellaire dans laquelle au moins la couche d'enregistrement, une couche de revêtement supérieure et la couche réfléchissante sont disposées sur le substrat dans cet ordre, et d'une structure lamellaire dans laquelle au moins la couche réfléchissante, une couche de revêtement supérieure, la

couche d'enregistrement et une couche de couverture sont disposées sur le substrat dans cet ordre.

5. Support d'enregistrement optique selon la revendication 2, où le support d'enregistrement optique est produit au moyen d'une cible de pulvérisation cathodique qui comprend un ou plusieurs choisis parmi $BiFeO_3$, $Bi_{25}FeO_{40}$ et $Bi_{36}Fe_2O_{57}$.

6. Support d'enregistrement optique à enregistrement unique et lectures multiples comprenant :

   un substrat,
   une couche d'enregistrement, et
   une couche réfléchissante,
   où la couche d'enregistrement comprend Bi, 0 et L comme éléments constitutifs, et la couche d'enregistrement comprend un oxyde de Bi, et
   où L représente au moins un élément choisi dans le groupe consistant en B, P, As, Se, Tc, Pd, Ag, Sb, Te, W, Re, Os, Ir, Pt, Au, Hg, Tl, Po, At et Cd.

7. Support d'enregistrement optique selon la revendication 6, où l'élément L représente au moins un élément choisi dans le groupe consistant en B, P, Se, Pd, Ag, Sb, Te, W, Pt et Au.

8. Support d'enregistrement optique selon la revendication 6, où le rapport en nombres d'atomes de la quantité totale de l'élément L au bismuth est 1,25 ou moins.

9. Support d'enregistrement optique selon la revendication 6, où le support d'enregistrement optique comprend en outre une couche de revêtement supérieure et a une structure lamellaire dans laquelle la couche d'enregistrement, la couche de revêtement supérieure et la couche réfléchissant sont disposées sur le substrat dans cet ordre.

10. Support d'enregistrement optique selon la revendication 9, où le support d'enregistrement optique comprend en outre une couche de revêtement inférieure et a une structure lamellaire dans laquelle la couche de revêtement inférieure, la couche d'enregistrement, la couche de revêtement supérieure et la couche réfléchissante sont disposées sur le substrat dans cet ordre.

11. Support d'enregistrement optique selon la revendication 6, où le support d'enregistrement optique comprend en outre une couche de revêtement supérieure et une couche de couverture et a une structure lamellaire dans laquelle la couche réfléchissante, la couche de revêtement supérieure, la couche d'enregistrement et la couche de couverture sont disposées sur le substrat dans cet ordre.

12. Support d'enregistrement optique selon la revendication 11, où le support d'enregistrement optique comprend en outre une couche de revêtement inférieure et a une structure lamellaire dans laquelle la couche réfléchissante, la couche de revêtement supérieure, la couche d'enregistrement, la couche de revêtement inférieure et la couche de couverture sont disposées sur le substrat dans cet ordre.

13. Support d'enregistrement optique selon la revendication 6, où le support d'enregistrement optique comprend en outre au moins l'une d'une couche de revêtement inférieure et d'une couche de revêtement supérieure, et au moins l'une quelconque de la couche de revêtement inférieure et de la couche de revêtement supérieure comprend ZnS et/ou $SiO_2$.

14. Support d'enregistrement optique selon la revendication 6, où le support d'enregistrement optique comprend en outre au moins l'une d'une couche de revêtement inférieure et d'une couche de revêtement supérieure, et au moins l'une quelconque de la couche de revêtement inférieure et de la couche de revêtement supérieure comprend un matériau organique.

15. Utilisation d'une cible de pulvérisation cathodique **caractérisée en ce que** la cible de pulvérisation cathodique comprend Bi, Fe et O pour former une couche d'enregistrement dans le support d'enregistrement optique à enregistrement unique et lectures multiples selon la revendication 2.

16. Utilisation selon la revendication 15, où la cible de pulvérisation cathodique consiste en Bi, Fe et O.

17. Utilisation selon l'une quelconque des revendications 15 à 16, où la cible de pulvérisation cathodique comprend un

oxyde de Bi et un oxyde de Fe, ou comprend un oxyde complexe de Bi et Fe.

**18.** Utilisation selon la revendication 17, où la cible de pulvérisation cathodique comprend l'oxyde complexe de Bi et Fe et comprend en outre un ou plusieurs choisis parmi l'oxyde de Bi et l'oxyde de Fe.

**19.** Utilisation selon la revendication 15, où la cible de pulvérisation cathodique comprend un ou plusieurs choisis parmi un oxyde de Bi, un oxyde de Fe et un oxyde complexe de Bi et Fe, et l'oxyde est un oxyde ayant une quantité d'oxygène plus faible que la composition stoechiométrique.

**20.** Utilisation selon l'une quelconque des revendications 15 à 19, où la cible de pulvérisation cathodique comprend un ou plusieurs choisis parmi $BiFeO_3$, $Bi_{25}FeO_{40}$ et $Bi_{36}Fe_2O_{57}$.

**21.** Utilisation selon l'une quelconque des revendications 15 à 20, où la cible de pulvérisation cathodique comprend $Bi_2O_3$ et/ou $Fe_2O_3$.

**22.** Utilisation selon l'une quelconque des revendications 15 à 21, où la cible de pulvérisation cathodique ne comprend pas $Bi_2Fe_4O_9$.

**23.** Utilisation selon l'une quelconque des revendications 15 à 22, où la teneur de Co, Ca et Cr est inférieure à la limite de détection de la spectrométrie d'émission plasma à couplage inductif.

**24.** Utilisation selon l'une quelconque des revendications 15 à 23, où la cible de pulvérisation cathodique a une densité de tassement de 65 % à 96 %.

**25.** Utilisation selon l'une quelconque des revendications 15 à 24, où le rapport atomique de Bi et Fe satisfait la condition $Bi/Fe \geq 0,8$.

**26.** Procédé comprenant :

la calcination de poudres de $Bi_2O_3$ et $Fe_2O_3$ seulement pour produire une cible de pulvérisation cathodique et l'utilisation de ladite cible de pulvérisation cathodique selon l'une quelconque des revendications 15 à 25.

FIG. 1

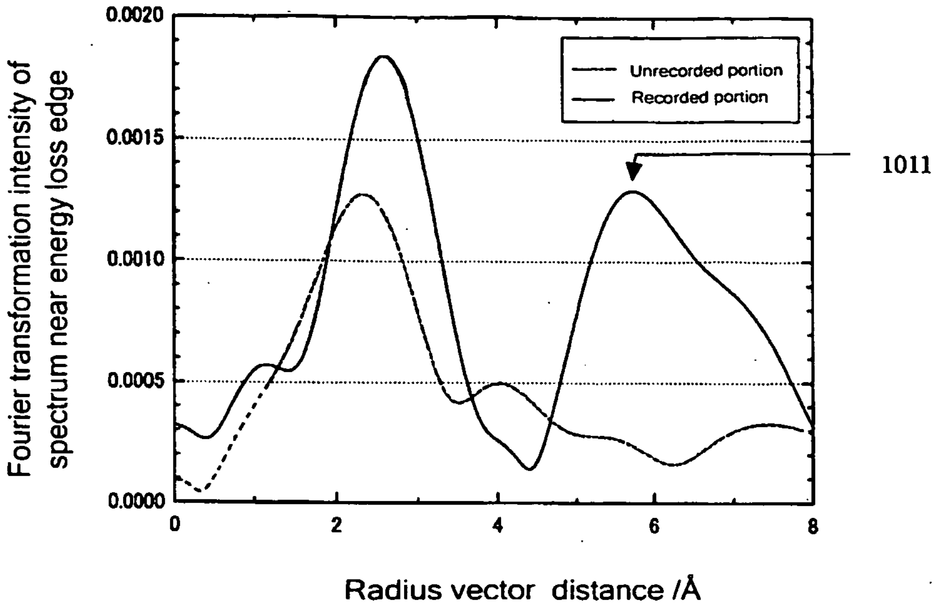
0.0020
0.0015
0.0010
0.0005
0.0000
0
2
4
6
8
Fourier transformation intensity of spectrum near energy loss edge
Radius vector distance /Å
Unrecorded portion
Recorded portion
1011

FIG. 2

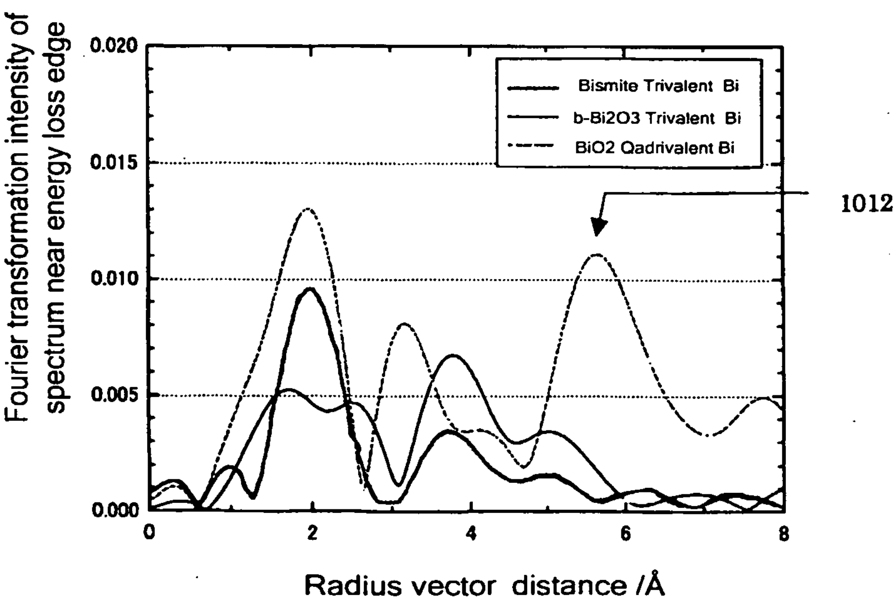
0.020
0.015
0.010
0.005
0.000
0
2
4
6
8
Fourier transformation intensity of spectrum near energy loss edge
Radius vector distance /Å
Bismite Trivalent Bi
b-Bi2O3 Trivalent Bi
BiO2 Qadrivalent Bi
1012

FIG. 3

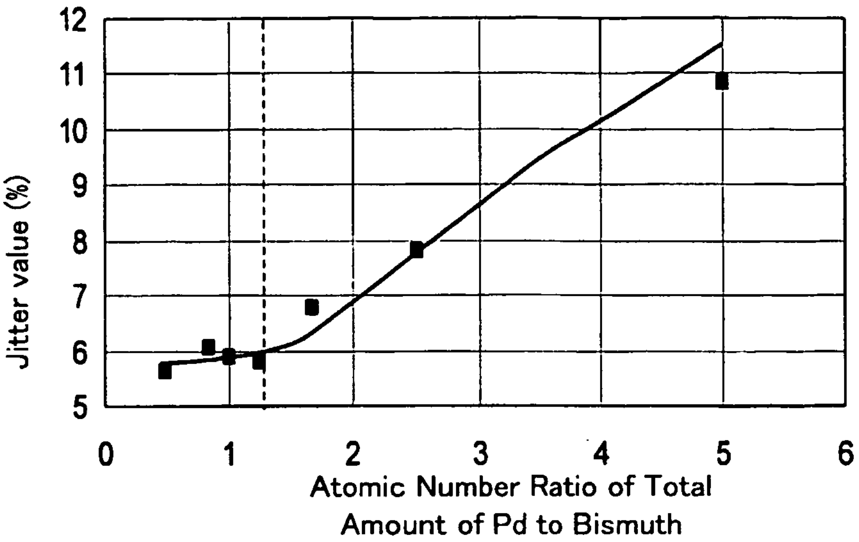
12
11
10
9
8
7
6
5
Jitter value (%)
0
1
2
3
4
5
6
Atomic Number Ratio of Total
Amount of Pd to Bismuth

FIG. 4

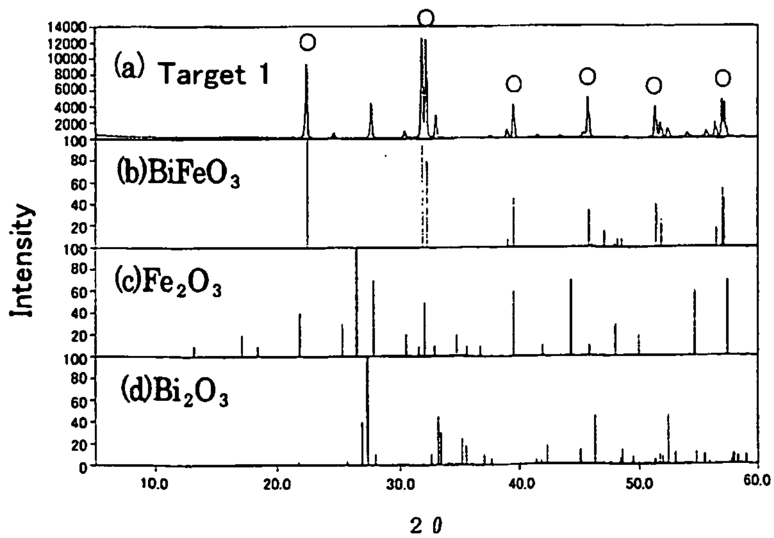
(a) Target 1
(b)BiFeO3
(c)Fe2O3
(d)Bi2O3
Intensity
10.0
20.0
30.0
40.0
50.0
60.0
2θ

FIG. 5

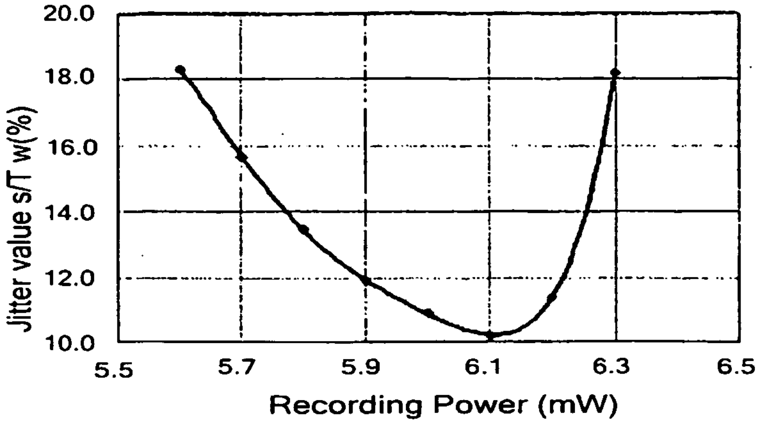
20.0
18.0
16.0
14.0
12.0
10.0
Jitter value s/T w(%)
5.5
5.7
5.9
6.1
6.3
6.5
Recording Power (mW)

FIG. 6

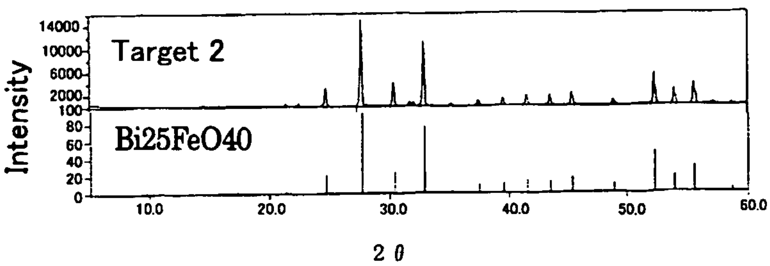
14000
10000
6000
2000
100
80
60
40
20
0
Intensity
Target 2
Bi25FeO40
10.0
20.0
30.0
40.0
50.0
60.0
2 θ

FIG. 7

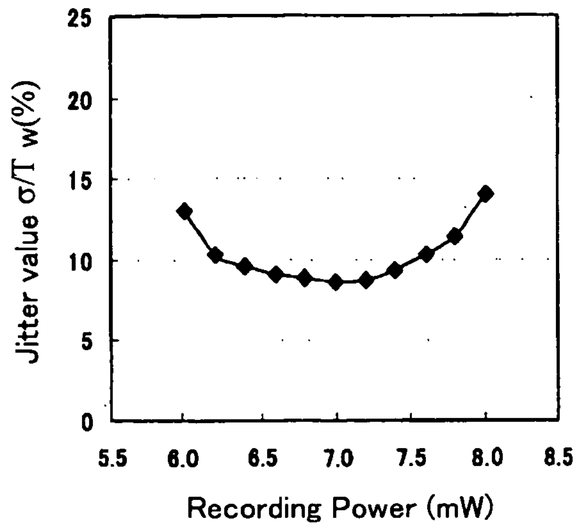
25
20
15
10
5
0
Jitter value σ/T w(%)
5.5
6.0
6.5
7.0
7.5
8.0
8.5
Recording Power (mW)

FIG. 8

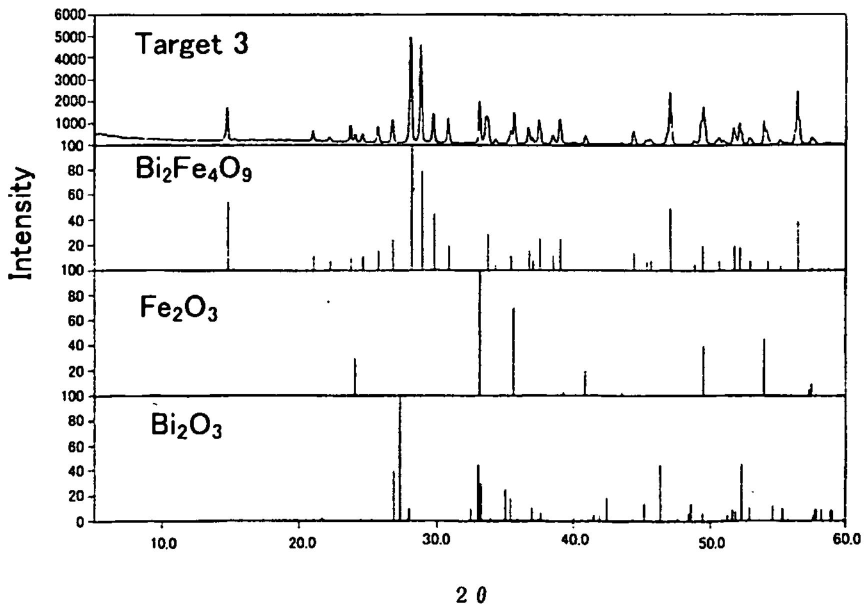
Target 3
Bi2Fe4O9
Fe2O3
Bi2O3
Intensity
6000
5000
4000
3000
2000
1000
100
80
60
40
20
0
10.0
20.0
30.0
40.0
50.0
60.0
2θ

FIG. 9

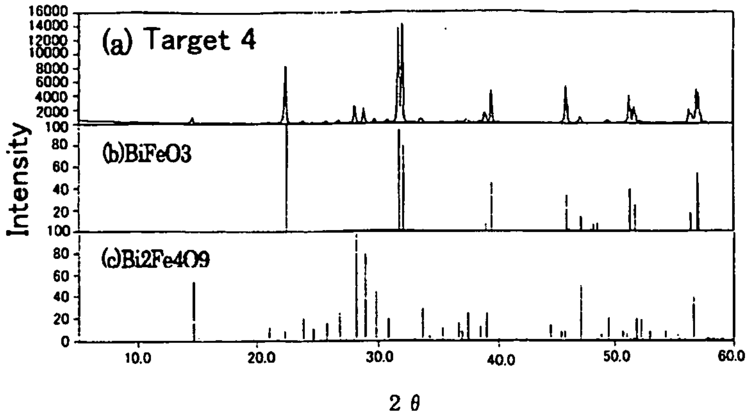
(a) Target 4
(b)BiFeO3
(c)Bi2Fe4O9
Intensity
16000
14000
12000
10000
8000
6000
4000
2000
100
80
60
40
20
0
10.0
20.0
30.0
40.0
50.0
60.0
2 θ

FIG. 10

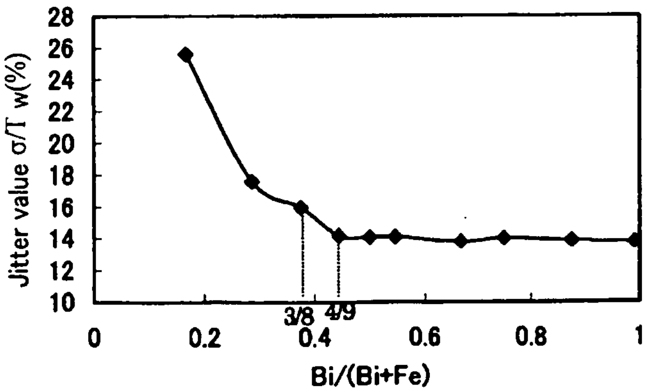
Jitter value σ/T w(%)
28
26
24
22
20
18
16
14
12
10
3/8
4/9
0
0.2
0.4
0.6
0.8
1
Bi/(Bi+Fe)

FIG. 11

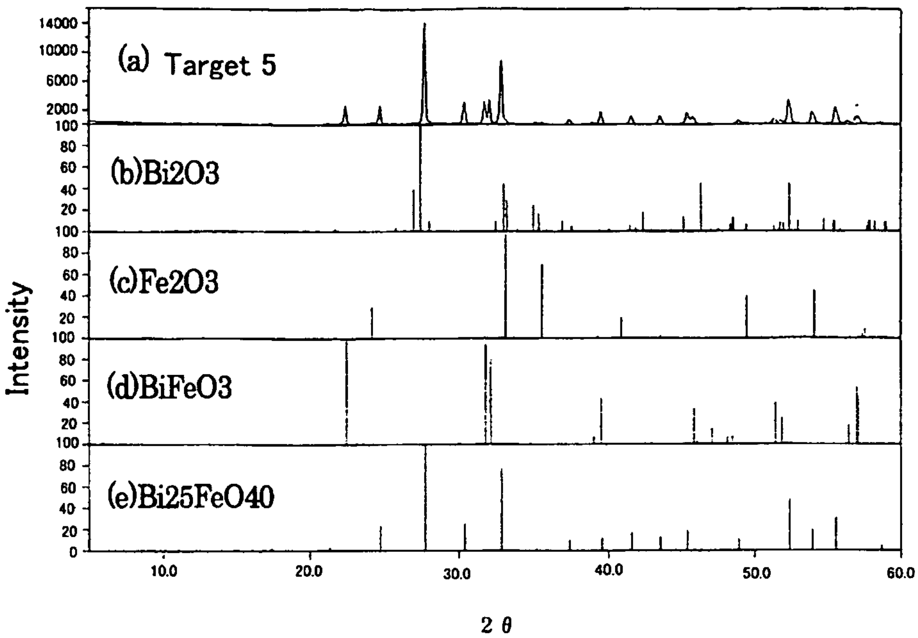
Intensity
14000
10000
6000
2000
100
80
60
40
20
0
(a) Target 5
(b)Bi2O3
(c)Fe2O3
(d)BiFeO3
(e)Bi25FeO40
10.0
20.0
30.0
40.0
50.0
60.0
2 θ

FIG. 12

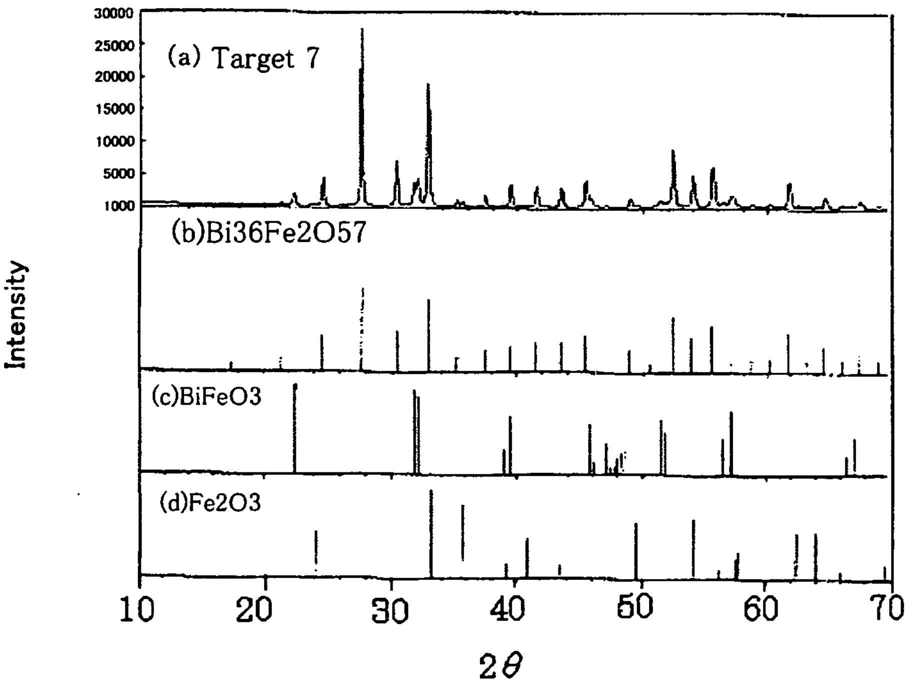
Intensity
30000
25000
20000
15000
10000
5000
1000
(a) Target 7
(b)Bi36Fe2O57
(c)BiFeO3
(d)Fe2O3
10
20
30
40
50
60
70
2θ

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 10092027 A
- JP 2003048375 A
- JP 6150366 A
- JP 6093300 A
- JP 61101450 A
- JP 61101448 A
- JP 59008618 A
- JP 59073438 A
- JP 11092922 A
- JP 2042899 A
- US 4278734 A


### Non-patent literature cited in the description


- *Proceedings of The 14th Symposium on PCOS2002,* 23-28
- *Eijogaku Giho,* vol. 28, 5-8
- Electrochemistry Handbook. Maruzen, vol. 5